(19) Europäisches Patentamt
European Patent Office
Office européen des brevets

(11) **EP 2 135 414 B1**

(12) **EUROPÄISCHE PATENTSCHRIFT**

| | |
|---|---|
| (45) Veröffentlichungstag und Bekanntmachung des Hinweises auf die Patenterteilung: **07.07.2010 Patentblatt 2010/27** | (51) Int Cl.: **H04L 25/02** *(2006.01)* **H03H 17/02** *(2006.01)* |
| (21) Anmeldenummer: **08734862.9** | (86) Internationale Anmeldenummer: **PCT/EP2008/002490** |
| (22) Anmeldetag: **28.03.2008** | (87) Internationale Veröffentlichungsnummer: **WO 2008/125206 (23.10.2008 Gazette 2008/43)** |

(54) **VERFAHREN ZUR OPTIMIERUNG EINER MINIMAL-PHASIGEN ÜBERTRAGUNGSCHARAKTERISTIK UND ZUGEHÖRIGES ÜBERTRAGUNGSSYSTEM**

METHOD FOR OPTIMIZING A MINIMAL-PHASE TRANSMISSION CHARACTERISTIC AND ASSOCIATED TRANSMISSION SYSTEM

PROCÉDÉ D'OPTIMISATION D'UNE CARACTÉRISTIQUE DE TRANSMISSION À PHASE MINIMALE ET SYSTÈME DE TRANSMISSION CORRESPONDANT

| | |
|---|---|
| (84) Benannte Vertragsstaaten: **AT BE BG CH CY CZ DE DK EE ES FI FR GB GR HR HU IE IS IT LI LT LU LV MC MT NL NO PL PT RO SE SI SK TR** | (72) Erfinder: **DETERT, Thorben 80634 München (DE)** |
| (30) Priorität: **17.04.2007 DE 102007018093** **20.08.2007 DE 102007039158** **26.11.2007 DE 102007056728** | (74) Vertreter: **Körfer, Thomas Mitscherlich & Partner Patent- und Rechtsanwälte Postfach 33 06 09 80066 München (DE)** |
| (43) Veröffentlichungstag der Anmeldung: **23.12.2009 Patentblatt 2009/52** | (56) Entgegenhaltungen: **EP-A- 1 032 170** **WO-A-01/58036** **WO-A-2007/053086** **US-A- 5 511 014** |
| (73) Patentinhaber: **Rohde & Schwarz GmbH & Co. KG 81671 München (DE)** | |

**Beschreibung**

Die Erfindung betrifft ein Verfahren zur Erzeugung bzw. Optimierung einer minimal-phasigen Übertragungscharakteristik aus einer nicht-minimal-phasigen Übertragungscharakteristik einer Übertragungsstrecke und ein zugehöriges Übertragungssystem.

Übertragungskanäle sind typischerweise durch Zeitveränderlichkeit, Intersymbol-Interferenzen und Gauß-verteiltes, weißes Rauschen gekennzeichnet. Zur Schätzung der übertragenen Datensymbol-Sequenzen ist im Empfänger ein Kanalschätzer und ein nachfolgender Entzerrer erforderlich. Die Entzerrung erfolgt typischerweise durch Zustandsschätzung im Trellis-Diagramm auf der Basis des Maximum-Likelihood-Ansatzes. Eine bekannte Realisierung stellt hierbei der Viterbi-Algorithmus dar. Problematisch ist hierbei die hohe Anzahl der zu berechnenden Zustände und Pfade im Trellis-Diagramm, die im Fall des Viterbi-Algorithmuses bei einer Kanallänge $L$ und einer Mächtigkeit $M$ des Symbolalphabets insgesamt $M^{L-1}$ Zustände und $M^L$ Pfade bedeutet.

In den letzten Jahren wurden deshalb auf der Basis des Viterbi-Algorithmuses suboptimale Verfahren mit einer gegenüber dem Viterbi-Algorithmus reduzierten Anzahl von Zuständen, wie beispielsweise der Delayed-Feedback-Sequence-Estimator (DDFSE) oder der Reduced-State-Sequence-Estimator (RRSE), entwickelt. Derartige suboptimale Entzerrungsverfahren werden im Kombination mit einem Vorfilter im Empfänger eingesetzt, das die Impulsantwort des Übertragungskanals verkürzt oder minimalphasig gestaltet und damit das Ausmaß an Intersymbol-Interferenzen minimiert.

Zum technologischen Hintergrund sei beispielsweise auf die WO 2007/053086 A1 verwiesen.

Da die Transformation einer üblicherweise nicht-minimal-phasigen Übertragungscharakteristik eines Übertragungskanals in eine minimal-phasige Übertragungscharakteristik mit einem in Allpass-Näherung realisierten Vorfilter erfolgt, wird das Rauschen aufgrund des frequenzinvarianten Amplitudengangs eines als Allpass realisierten Vorfilters nicht zusätzlich verstärkt. Somit ist die Realisierungsvariante eines minimalphasigen Vorfilters dem impulsverkürzenden Vorfilter vorzuziehen.

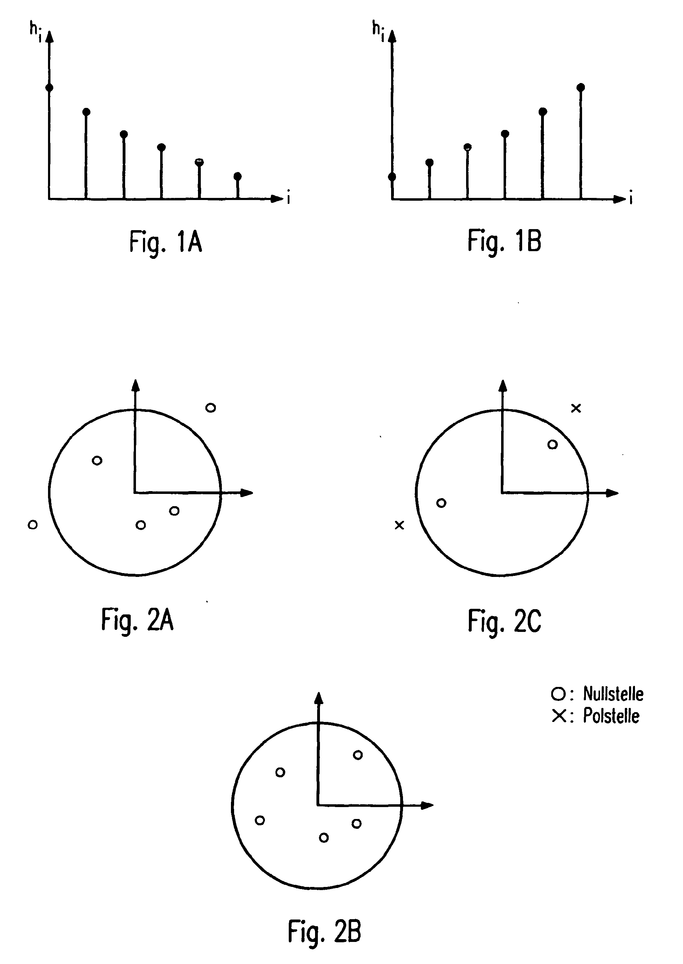

Ein minimal-phasiger Übertragungskanal ist gemäß Fig. 1A gegenüber einem nicht-minimalphasigen Übertragungskanal, insbesondere einem maximal-phasigen Übertragungskanal gemäß Fig. 1B, durch eine Konzentration der Signalenergie am Beginn der Kanalimpulsantwort gekennzeichnet, womit eine der Energiekomprimierung eines impulsverkürzenden Vorfilters entsprechende Übertragungscharakteristik gegeben ist. Neben einer minimalen Gruppenlaufzeit weist der minimal-phasige Übertragungskanal als weiteres Charakteristikum eine diskrete Übertragungsfunktion $H(z)$ mit Pol- und Nullstellen innerhalb des Einheitskreises in der komplexen z-Ebene auf, was in den Figuren 2A bis 2C veranschaulicht ist.

Die Verfahren des Stands der Technik zur Transformation eines Übertragungskanals mit einer nicht-minimalphasigen Übertragungscharakteristik in eine minimal-phasige Übertragungscharakteristik basieren deshalb im wesentlichen alle darauf, im Empfänger eine Signalverarbeitungsfunktion zu realisieren, die ausgehend von der diskreten Übertragungsfunktion $H(z)$ des Übertragungskanals aus der Sicht des Entzerrers einen "virtuellen Übertragungskanal" mit einer Übertragungsfunktion $H_{Min}(z)$ erzeugt, deren Pol- und Nullstellen einzig innerhalb des Einheitskreises in der komplexen z-Ebene liegen.

Die gängige Signalverarbeitungskette in einem Empfänger vor dem Detektor besteht aus einem als Tiefpassfilter realisierten Empfangsfilter, einem Matched-Filter zur Optimierung des Signal-Rausch-Abstands und einem nachgeschalteten Whitening-Filter mit Allpasscharakteristik zur Erzeugung eines weißen Rauschens aus dem durch den frequenzvarianten Amplitudengang des Matched-Filters farbig gewordenen Rauschen im Empfangssignal. Da die Übertragungscharakteristik des Empfangsfilters in Analogie zur Übertragungscharakteristik des Sendefilters der Übertragungscharakteristik des Übertragungskanals üblicherweise zugewiesen wird, wird das Übertragungsverhalten des Matched-Filters und des Whitening-Filters bei den Verfahren des Stands der Technik im Hinblick auf Minimalphasigkeit der vor dem Entzerrer gelegenen Übertragungsstrecke ausgelegt.

Bislang wird die Cepstrum-Funktion des Faltungsergebnisses der diskreten Kanalimpulsantwort $h(k)$ des aus Sendefilter, Übertragungskanal und Empfangsfilter bestehenden Übertragungsstrecke mit der diskreten Impulsantwort $h^*(-k)$ des Matched-Filters ermittelt. Wie weiter unten noch im Detail gezeigt wird, läßt sich aus der somit berechneten Ceptrum-Funktion der minimal-phasige Übertragungsanteil der Übertragungsstrecke vor dem Entzerrer ermitteln.

Nachteilig an diesem Ansatz zur Gestaltung einer Minimal-phasigkeit der Übertragungsstrecke vor dem Entzerrer ist die Tatsache, dass sowohl die Übertragungscharakteristik des Übertragungskanals als auch die von der Übertragungscharakteristik des Übertragungskanals abhängige Übertragungscharakteristik des Matched-Filters und damit eine Übertragungscharakteristik mit einer gegenüber der Übertragungscharakteristik des reinen Übertragungskanals doppelten Anzahl von Null- und Polstellen in den Entwurf des Matched-Filters als Vorfilter zur Erzeugung einer Minimalphasigkeit der Übertragungstrecke eingeht. Die höhere Komplexität dieser Übertragungscharakteristik bedingt eine geringer zu erzielende Minimalphasigkeit und damit unerwünscht eine höhere Anzahl von Zuständen im Trellis-Diagramm.

Da die Bandbreite des gesendeten Signals größer als der Symboltakt $\frac{1}{T}$ ist und das analoge Empfangssignal

$r(t)$ nach einem analogen Empfangsfilter im Symboltakt $\frac{1}{T}$ abgetastet wird, kommt es zu Aliasing. Das im Symboltakt $\frac{1}{T}$ arbeitende digitale Empfangsfilter mit der diskreten Impulsantwort $h^*(-k)$ ist somit in der Regel kein Matched-Filter, da es in der Regel das Signal-Rausch-Verhältnis nicht maximiert.

Druckschrift US 5 511 014 A beschreibt ein Verfahren und eine Vorrichtung zur Überführung einer nicht-minimal-phasigen Übertragungsstrecke in eine minimal-phasige Übertragungsstrecke durch Kaskadierung der nicht-minimal-phasigen Übertragungsstrecke mit einem Vorfilter, wobei die minimal-phasige Übertragungsstrecke auf Basis der Cepstrum- Funktion der nicht- minimal- phasigen Übertragungsstrecke ermittelt wird. Zur numerischen Vereinfachung bei der Ermittlung der Filterkoeffizienten des Vorfilters wird aber die Ordnung des Polynoms der Übertragungscharakteristik des Vorfilters reduziert. Dies führt zu einer nicht optimalen Minimal-Phasigkeit der Gesamtübertragungsstrecke.

Aufgabe der Erfindung ist es deshalb, ein Verfahren zur Optimierung einer einem Entzerrer vorgelagerten, minimal-phasigen Übertragungsstrecke und ein Übertragunssystem zugehörigen Übertragungsstrecke, die mittels Cepstrum-Funktion aus der nicht-minimal-phasigen Übertragungsstrecke ermittelt wird, derart weiterzuentwickeln, dass die höchst mögliche Minimalphasigkeit erzielt wird.

Die Erfindungsaufgabe wird durch das erfindungsgemäße Verfahren mit den Merkmalen des unabhängigen Patentanspruchs 1 und durch das erfindungsgemäße Übertragunssystem mit den Merkmalen des unabhängigen Patentanspruchs 10 gelöst.

Erfindungsgemäß geht in die Bestimmung der minimal-phasigen Übertragungscharakteristik der Übertragungsstrecke, bestehend aus Übertragungskanal und Vorfilter, einzig die nicht-minimal-phasige Übertragungscharakteristik des Übertragungskanals ein, die gegenüber der bisher üblichen Übertragungscharak-teristik der Übertragungsstrecke eine geringere Anzahl von Null- und Polstellen aufweist und somit mittels der Cepstrum-Funktion in eine Übertragungsstrecke mit einem höheren Grad an Minimalphasigkeit überführbar ist. Eine Übertragungsstrecke mit einer derart optimierten Minimalphasigkeit führt im nachgeschalteten Entzerrer zu einer geringeren Anzahl von Zuständen und Pfaden im Trellis-Diagramm und damit zu einer rechen-effizienteren Entzerrung des Empfangsignals.

Auch ist das erfindungsgemäße Verfahren mit einem geringeren Entwurfsaufwand verbunden, da zur Bestimmung der minimal-phasigen Übertragungscharakteristik der Übertragungsstrecke einzig die Kanalimpulsantwort $h(k)$ geschätzt werden muß und die anschließende Ermittlung der Impulsantwort $h^*(-k)$ des Matched-Filters aus der Schätzung der Kanalimpulsantwort $h(k)$ des Übertragungskanals, wie sie im Stand der Technik realisiert ist, entfällt. Als weiterer technischer Vorteil der Erfindung ist die Verwendung eines einzigen Vorfilters anstelle der Kombination eines Matched-Filters und eines Whitening-Filters wie im Stand der Technik hervorzuheben.

Nach Bestimmung der Impulsantwort $\tilde{h}_{min}$ der minimal-phasigen Übertragungsstrecke mittels Cepstrum-Funktion werden in einer ersten Ausführungsform des erfindungsgemäßen Verfahrens die Filterkoeffizienten $\tilde{w}$ des linearen Vorfilters durch Minimierung der Fehlerquadrate zwischen dem mit den Filterkoeffizienten $\tilde{w}$ des Vorfilters gewichteten, am Ausgang der Übertragungsstrecke mit nicht-minimal-phasiger Übertragungscharakteristik empfangenen Signal $\tilde{r}$ und der mit der zur minimal-phasigen Übertragungscharakteristik der Übertragungsstrecke gehörigen Impulsantwort $\tilde{h}_{min}$ gefalteten gesendeten Datensymbol-Sequenz ermittelt.

In einer zweiten Ausführungsform des erfindungsgemäßen Verfahrens werden die Filterkoeffizienten $\tilde{w}$ des linearen Vorfilters durch Lösen eines linearen Gleichungssystems ermittelt, bei dem die Multiplikation der Übertragungsmatrix $\underline{H}$ der Übertragungsstrecke mit nicht-minimal-phasiger Übertragungscharakteristik mit dem Vektor der Filterkoeffizienten des linearen Vorfilters dem Vektor der Impulsantwort $\tilde{h}_{min}$ der Übertragungsstrecke mit minimal-phasiger Übertragungscharakteristik gleichgesetzt wird. Dem Vorfilter ist ein Abtaster zur Abtastung des Empfangsignals im vollen, doppelten oder $n$-fachen Symboltakt vorgeschaltet.

Bei komplexen zu entzerrenden Übertragungskanälen - beispielsweise bei höherer Zeitveränderlichkeit und bei einem höheren Anteil an Intersymbol-Interferenzen aufgrund einer größeren Kanallänge $L_h$ - wird der Übertragungskanal typischerweise nicht mit vollem Symboltakt, sondern mit doppeltem bzw. $n$-fachen Symboltakt abgetastet. In diesem Fall werden vorteilhafterweise in einer zweiten Ausführungsform der erfindungsgemäßen Übertragungsstrecke zwei bzw. $n$ identische Vorfilter parallel geschaltet, die über einen ersten Umschalter jeweils abwechselnd jeden zweiten bzw. $n$-ten Abtastwert des im doppelten bzw. $n$-fachen Symboltakt abgetasteten Empfangssignals erhalten. Über einen zweiten Umschalter werden die jeweils vorgefilterten Abtastwerte des Empfangssignals an den Ausgängen der beiden parallel geschalteten Vorfilter zur Erzeugung eines einzigen vorgefilterten Empfangssignals mit Abtastwerten im doppelten bzw. $n$-fachen Symboltakt am einzigen Eingang des nachfolgenden Entzerrers zusammengeführt.

Für die Berechnung der Filterkoeffizienten $\tilde{w}$ des/r Vorfilter mittels numerischer Minimierung der Fehler-quadrate ist eine komplexere Matrixinversion erforderlich, die insbesondere bei einer großen Filterlänge $L_{AP}$ des/r Vorfilter sehr rechenaufwändig wird. In einer vorteilhaften Ausgestaltung des erfindungsgemäßen Verfahrens und der erfindungsgemäßen Übertragungsstrecke werden die einzelnen Filterkoeffizienten mittels eines rekursiven Berechnungsverfahrens vergleichsweise aufwandsminimiert ermittelt.

Das erfindungsgemäße Verfahren zur Erzeugung bzw. Optimierung einer mini-mal-phasigen Übertragungscharakteristik aus einer nicht-minimal-phasigen Übertragungscharakteristik einer Übertra-gungsstrecke und die zugehörige erfindungsgemäße Übertra-gungsstrecke werden im Folgenden anhand der Zeichnung im Detail erläutert. Die Figuren der Zeichnung zeigen:

Fig. 1A, 1B      ein Zeitdiagramm einer minimal-phasigen und einer maximal-phasigen Impulsant- wort,

Fig: 2A, 2B, 2C      ein Pol-/Nullstellen-Diagramm einer nicht-minmal-phasigen Übertragungs- strecke, einer minimal-phasigen Über- tragungsstrecke und eines zugehörigen Allpassfilters,

Fig. 3      ein Blockdiagramm einer ersten Ausfüh- rungsform der erfindungsgemäßen Über- tragungsstrecke,

Fig. 4      ein Blockdiagramm einer zweiten Ausfüh- rungsform der erfindungsgemäßen Über- tragungsstrecke,

Fig. 5      ein Flussdiagramm der ersten und zweiten Ausführungsform eines erfindungsgemäßen Verfahrens zur Erzeugung einer minimal- phasigen Übertragungscharakteristik aus einer nicht-minimal-phasigen Übertra- gungscharakteristik einer Übertragungs- strecke,

Fig. 6A      ein Flussdiagramm eines rekursiven Ver- fahrens zur näherungsweisen Berechnung der Filterkoeffizienten eines Vorfil- ters für die erste Ausführungsform des erfindungsgemäßen Verfahrens zur Erzeu- gung einer minimal-phasigen Übertra- gungscharakteristik aus einer nicht- minimal-phasigen Übertragungscharak- teristik einer Übertragungsstrecke,

Fig. 6B      ein Flussdiagramm eines rekursiven Ver- fahrens zur näherungsweisen Berechnung der Filterkoeffizienten eines Vorfil- ters für die zweite Ausführungsform des erfindungsgemäßen Verfahrens zur Erzeu- gung einer minimal-phasigen Übertra- gungscharakteristik aus einer nicht- minimal-phasigen Übertragungscharak- teristik einer Übertragungsstrecke,

Fig. 7      ein Zeitdiagramm einer nicht-minimal- phasigen Impulsantwort und der zuge- hörigen minimal-phasigen Impulsantwort und

Fig. 8A, 8B      ein Amplituden- und Phasengang eines Vorfilters der erfindungsgemäßen Über- tragungsstrecke.

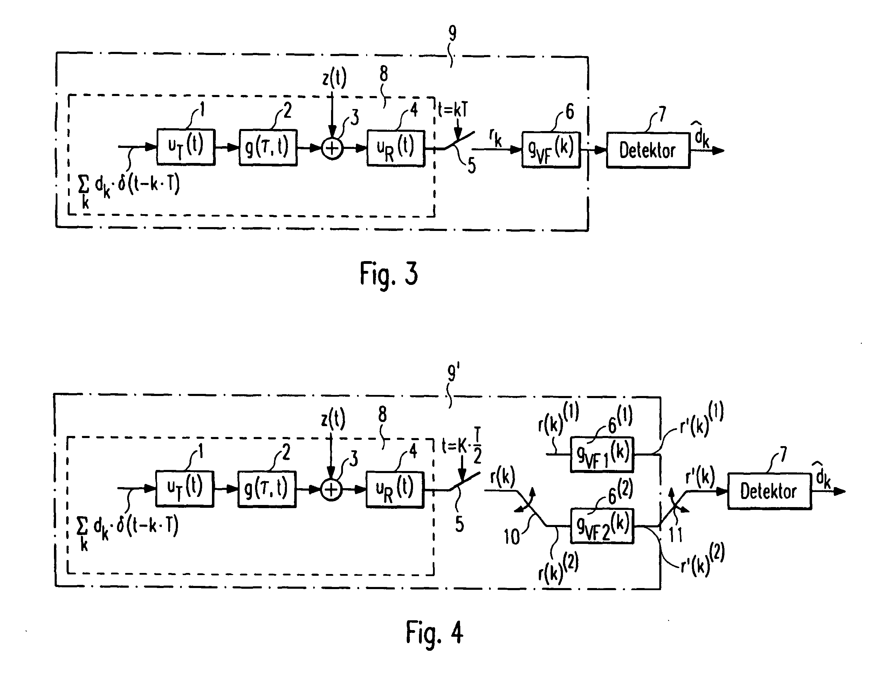

Bevor das erfindungsgemäße Verfahren zur Erzeugung bzw. Optimierung einer minimal-phasigen Übertragungscharakteristik aus einer nicht-minimal-phasigen Übertragungscharakteristik einer Übertragungsstrecke und die zugehörige erfindungsgemäße Übertragungsstrecke anhand der Fig. 3 bis 7B im Detail erläutert werden, werden im Folgenden die für das Ver-ständnis der Funktionsweise der Erfindung erforderlichen mathematischen Grundlagen hergeleitet.

Jede Übertragungsstrecke mit der diskreten Übertragungsfunktion $H(z)$ läßt sich gemäß Gleichung (1) in ein minimal-phasiges Teilübertragungssystem mit der Übertragungsfunktion $H_{min}(z)$ und in ein Allpassfiltersystem mit der Übertragungsfunktion $H_{All}(z)$ zerlegen.

$$H(z) = H_{\min}(z) \cdot H_{all}(z) \qquad\qquad (1)$$

Zur Erzeugung einer minimal-phasigen Übertragungsstrecke aus einer nicht-minimal-phasigen Übertragungsstrecke ist folglich gemäß Gleichung (2) ein der nicht-minimal-phasigen Übertragungsstrecke $H(z)$ nachgeschaltetes Vorfilter erforderlich, dessen Übertragungsfunktion der inversen Übertragungsfunktion $H_{all}(z)^{-1}$ eines zum minimal-phasigen Teilübertragungssystem korrespondierenden Allpassfiltersystems entspricht.

$$H_{\min}(z) = H(z) \cdot H_{all}(z)^{-1} \qquad\qquad (2)$$

In Anlehnung an die WO 2007/053086 A1 können im cepstralen Be-reich die minimal-phasigen Anteile der Cepstrum-Funktion einer zur nicht-minimal-phasigen Übertragungsstrecke $H(z)$ gehörigen diskreten Impulsantwort $h(k)$ ermittelt werden und durch Anwendung der inversen Cepstrum-Funktion auf die somit ermittelten minimal-phasigen Anteile der Cepstrum-Funktion die zur minimal-phasigen Übertragungsstrecke $H_{min}(z)$ gehörige diskrete minimal-phasige Impulsantwort $h_{min}(k)$ berechnet werden.

Die diskrete Übertragungsfunktion $H(z)$ der nicht-minimal-phasigen Übertragungsstrecke ergibt sich gemäß Gleichung (3) durch Z-Transformation aus der zugehörigen diskreten nicht-minimal-phasigen Impulsantwort $h(k)$:

$$H(z) = \sum_{k=0}^{N} h(k) \cdot z^{-k} \qquad (3)$$

Die reelle Cepstrum-Funktion $\hat{H}(z)$ entspricht gemäß Gleichung (4) dem natürlich logarithmierten Betrag der Z-Transformierten der diskreten Impulsantwort $h(k)$:

$$\widehat{H}(z) = \ln(|H(z)|) = \ln\left(\sqrt{H(z) \cdot H(z^{-1})}\right) \qquad (4)$$

Wird die Beziehung der diskreten Übertragungsfunktion $H(z)$ in Gleichung (3) in eine dazu äquivalente Darstellung mit den Nullstellen $\alpha_k$ gemäß Gleichung (5) umgeformt, so ergibt sich für dien Betrag $|H(z)|$ der diskreten Übertragungsfunktion $H(z)$ die mathematische Beziehung in Gleichung (6).

$$H(z) = \sum_{k=0}^{N} h(k) \cdot z^{-k} \triangleq A \cdot \prod_{k=1}^{N} (1 - \alpha_k \cdot z^{-1}) \qquad (5)$$

$$|H(z)| = \sqrt{H(z) \cdot H(z^{-1})} = A \cdot \sqrt{\prod_{k=1}^{N} (1 - \alpha_k \cdot z^{-1}) \cdot (1 - \alpha_k \cdot z)} \qquad (6)$$

Die reelle Cepstrum-Funktion $\hat{H}(z)$ ergibt sich folglich gemäß Gleichung (7).

$$\widehat{H}(z) = \ln A + \frac{1}{2} \sum_{k=1}^{N} (1 - \alpha_k \cdot z^{-1}) + \frac{1}{2} \sum_{k=1}^{N} (1 - \alpha_k \cdot z) \qquad (7)$$

Während die Nullstellen $\alpha_k$ des ersten Summenterms innerhalb des Einheitskreises in der komplexen z-Ebene liegen und im Folgenden zur Unterscheidung mit $\beta_k$ bezeichnet werden, liegen die Nullstellen $\frac{1}{\alpha_k}$ des zweiten Summenterms außerhalb des Einheitskreises in der komplexen z-Ebene und werden im Folgenden zur Unterscheidung mit $\gamma_k$ bezeichnet. Dies ist in den Figuren 2A bis 2C veranschaulicht. Die somit aus Gleichung (7) entstehenden Summenterme $\ln(1-\beta_k \cdot z^{-1})$ und $\ln(1-\gamma_k \cdot z)$ können entsprechend der Beziehungen in Gleichung (8) und (9) umgeformt werden und führen die Beziehung für die Cepstrum-Funktion $\hat{H}(z)$ in Gleichung (7) nach Gleichung (10) über.

$$\ln(1 - \beta_k \cdot z^{-1}) = -\sum_{n=1}^{\infty} \frac{\beta_k^n}{n} z^{-n} \quad |z| > |\alpha_k| \qquad (8)$$

$$\ln(1 - \gamma_k \cdot z) = -\sum_{n=1}^{\infty} \frac{\gamma_k^{\,n}}{n} z^n \qquad |z| < |\gamma_k^{-1}| \qquad (9)$$

$$\widehat{H}(z) = \ln A - \sum_{n=1}^{\infty} \frac{1}{2n} \sum_{k=1}^{N} \beta_k^{\,n} \cdot z^{-n} - \sum_{n=1}^{\infty} \frac{1}{2n} \sum_{k=1}^{N} \gamma_k^{\,n} \cdot z^n \qquad (10)$$

Analog zur mathematischen Beziehung der Z-Transformation zwischen der diskreten Übertragungsfunktion $H(z)$ und der zugehörigen diskreten Impulsantwort $h(k)$ in Gleichung (3) kann für die reelle Cepstrum-Funktion $\widehat{H}(z)$ und den zugehörigen Koeffizienten $\hat{h}(k)$ eine der Z-Transformation entsprechende Transformation gemäß Gleichung (11) gebildet werden.

$$\widehat{H}(z) = \sum_{k=-\infty}^{\infty} \hat{h}(k) \cdot z^{-k} \qquad (11)$$

Ein Koeffizient-Vergleich zwischen Gleichung (10) und Gleichung (11) ergibt die mathematische Beziehung für die Koeffizienten $\hat{h}(k)$ der reellen Cepstrum-Funktion $\widehat{H}(z)$ in Gleichung (12).

$$\hat{h}(k) = \begin{cases} -\dfrac{1}{2n} \displaystyle\sum_{k=1}^{N} \gamma_k^{\,n} & n > 0 \\[2ex] \ln A & n = 0 \\[2ex] \dfrac{1}{2n} \displaystyle\sum_{k=1}^{N} \beta_k^{\,-n} & n < 0 \end{cases} \qquad (12)$$

Die komplexe Cepstrum-Funktion $\widehat{H}(z)$ gemäß Gleichung (13) besitzt, wie auch aus Gleichung (13) hervorgeht, nur Nullstellen $\alpha_k$ innerhalb des Einheitskreises in der komplexen z-Ebene und ist deshalb minimalphasig.

$$\widehat{H}(z) = \ln(H(z)) = \ln A + \sum_{k=1}^{N} (1 - \alpha_k \cdot z^{-1}) = \widehat{H}_{\min}(z) \qquad (13)$$

Die zugehörigen Koeffizienten $\hat{h}_{\min}(k)$ der komplexen Cepstrum-Funktion $\widehat{H}_{\min}(z)$ ergeben sich bei analoger Herleitung gemäß Gleichung (14).

$$\hat{h}_{\min}(k) = \begin{cases} -\dfrac{1}{n} \displaystyle\sum_{k=1}^{N} \gamma_k^{\,n} & n > 0 \\[2ex] \ln A & n = 0 \\[2ex] 0 & n < 0 \end{cases} \qquad (14)$$

Die Koeffizienten $\hat{h}_{\min}(k)$ der komplexen minimalphasigen Cepstrum-Funktion $\widehat{H}_{\min}(z)$ ergeben sich durch Vergleich von Gleichung (12) und (14) aus den Koeffizienten $\hat{h}(k)$ der reeellen, nicht-minimal-phasigen Cepstrum-Funktion $\widehat{H}(z)$ gemäß Gleichung (15).

$$\hat{h}_{\min}(k) = \begin{cases} 2 \cdot \hat{h}(k) & n > 0 \\ \hat{h}(k) & n = 0 \\ 0 & n < 0 \end{cases} \tag{15}$$

Die komplexe minimal-phasige Cepstrum-Funktion $\hat{H}_{\min}(z)$ ergibt sich in Analogie zu Gleichung (11) bei der reellen Cepstrum-Funktion aus den zugehörigen minimalphasigen Koeffizienten $\hat{h}_{\min}(k)$ gemäß Gleichung (16):

$$\hat{H}_{\min}(z) = \sum_{k=-\infty}^{\infty} \hat{h}_{\min}(k) \cdot z^{-k} \tag{16}$$

Die diskrete minimal-phasige Übertragungsfunktion $H_{\min}(z)$ ergibt sich durch Inversion der Gleichung (13) aus der komplexen minimal-phasigen Cepstrum-Funktion $\hat{H}_{\min}(z)$ gemäß Gleichung (17).

$$H_{\min}(z) = \exp\left(\hat{H}_{\min}(z)\right) \tag{17}$$

Die diskrete minimal-phasige Impulsantwort $h_{\min}(k)$ ergibt sich durch inverse Z-Transformation aus der diskrete minimal-phasige Übertragungsfunktion $H_{\min}(z)$ gemäß Gleichung (18), die bei Auflösung des Kreisintegrals C über den Einheitskreis in der komplexen z-Ebene in die inverse diskrete Fourier-Transformation des diskreten minimal-phasigen Fourier-Spektrums $\hat{H}_{\min}(e^{j\omega})$ übergeht.

$$h_{\min}(k) = \frac{1}{2\pi j} \oint_C H_{\min}(z) \cdot z^{n-1} dz = \frac{1}{2\pi} \int_{-\pi}^{\pi} H_{\min}(e^{j\omega}) \cdot e^{j\omega} d\omega \tag{18}$$

In der Praxis wird die Z-Transformation durch die diskrete Fourier-Transformation, typischerweise mit einer Fast-Fourier-Transformation (FFT) ersetzt, so dass in Analogie zu Gleichung (3) das diskrete Fourier-Spektrum $H(e^{j\omega_n})$ gemäß Gleichung (19) aus der diskreten Impulsantwort $h(k)$ ermittelbar ist.

$$H(e^{j\omega_n}) \triangleq H(n) = FFT\{h(k)\} = \frac{1}{M} \sum_{k=0}^{M-1} h(k) \cdot e^{-j\frac{kn2\pi}{M}} \quad \text{für } n=0,1,\ldots,M-1 \tag{19}$$

Das reelle Cepstrum-Funktion $\hat{H}(e^{j\omega_n})$ ergibt sich in Analogie zu Gleichung (4) gemäß Gleichung (20) aus dem diskreten Fourier-Spektrum $H(e^{j\omega_n})$:

$$\hat{H}(e^{j\omega_n}) = \ln\left(\left|H(e^{j\omega_n})\right|\right) \tag{20}$$

Die Koeffizienten $\hat{h}(k)$ der reellen, nicht-minimal-phasigen Cepstrum-Funktion $\hat{H}(e^{j\omega_n})$ ergeben sich in Analogie zu Gleichung (18) aus der reellen Cepstrum-Funktion $\hat{H}(e^{j\omega_n})$ gemäß Gleichung (21):

$$\hat{h}(k) = IFFT\left\{\widehat{H}(e^{j\omega_n})\right\} \triangleq IFFT\left\{\widehat{H}(n)\right\} = \sum_{n=0}^{M-1} \widehat{H}(n) \cdot e^{j\frac{nk2\pi}{M}}$$

$$\text{für } k=0,1,\ldots,M-1 \qquad\qquad (21)$$

Die Koeffizienten $\hat{h}_{min}(k)$ der komplexen, minimal-phasigen Cepstrum-Funktion $\hat{H}_{min}(e^{j\omega}{}_n)$ ergeben sich in Analogie zu Gleichung (15) aus den Koeffizienten $\hat{h}(k)$ der reellen, nicht-minimal-phasigen Cepstrum-Funktion $\hat{H}(e^{j\omega}{}_n)$ gemäß Gleichung (22).

$$\hat{h}_{min}(k) = \begin{cases} 2 \cdot \hat{h}(k) & n = 1,2,\ldots,\dfrac{M}{2} \\ \hat{h}(k) & n = 0 \\ 0 & n = \dfrac{M}{2}+1,\ldots,M-1 \end{cases} \qquad\qquad (22)$$

Die diskrete minimal-phasige Übertragungsfunktion $H_{min}(e^{j\omega}{}_n)$ ergibt sich in Analogie zu Gleichung (16) und (17) aus der Exponentialfunktion des diskreten Fourier-Spektrums $H_{min}(e^{j\omega}{}_n)$ der diskreten minimal-phasigen Impulsantwort $\hat{h}_{min}(k)$ gemäß Gleichung (23):

$$H_{min}(e^{j\omega_n}) \triangleq H_{min}(n) = \exp\left(FFT\left\{\hat{h}_{min}(k)\right\}\right) = \exp\left(\frac{1}{M}\sum_{k=0}^{M-1} \hat{h}_{min}(k) \cdot e^{-j\frac{kn2\pi}{M}}\right)$$

$$\text{für } n=0,1,\ldots,M-1 \qquad (23)$$

Die diskrete minimal-phasige Impulsantwort $h_{min}(k)$ ergibt sich schließlich in Analogie zu Gleichung (18) mittels diskreter inverser Fourier-Transformation aus der diskreten minimal-phasigen Übertragungsfunktion $H_{min}(e^{j\omega n})$ gemäß Gleichung (24).

$$h_{min}(k) = IFFT\left\{H_{min}(e^{j\omega_n})\right\} \triangleq IFFT\left\{H_{min}(n)\right\} = \sum_{n=0}^{M-1} H_{min}(n) \cdot e^{j\frac{nk2\pi}{M}}$$

$$\text{für } k=0,1,\ldots,M-1 \qquad (24)$$

Im Folgenden werden auf der Basis einer derart ermittelten diskreten minimal-phasigen Impulsantwort $h_{min}(k)$ die Filterkoeffizienten $\tilde{w}$ eines dem nicht-minimal-phasigen Übertragungskanal nachgeschalteten linearen Vorfilters hergeleitet, dessen Übertragungsfunktion in Anlehnung an Gleichung (2) der inversen Übertragungsfunktion $H_{all}(z)^{-1}$ eines zum minimal-phasigen Teilübertragungssystem korrespondierenden Allpassfiltersystems entspricht.

Hierzu wird in einer ersten Ausführungsform des erfindungsgemäßen Verfahrens entsprechend einem Least-Squares-Ansatz der Erwartungswert der Fehlerquadrate zwischen dem mit den Filterkoeffizienten $\tilde{w}$ des Vorfilters gefalteten Empfangssignal $\tilde{r}$ und der mit der minimal-phasigen Impulsantwort $\tilde{h}_{min}$ der aus Übertragungskanal und Vorfilter bestehenden Übertragungsstrecke gefalteten gesendeten Datensymbol-Sequenz $\underline{d}_D$ minimiert. In den Erwartungswert der zu minimierenden Kostenfunktion $C$ gehen gemäß Gleichung (25) nicht nur die Fehlerquadrate sondern auch die zu minimierende Norm $\|\tilde{w}\|^2$ der Filterkoeffizienten $\tilde{w}$ des Vorfilters ein. Die mit dem reellen Faktor $\varepsilon$ gewichtete Norm $\|\tilde{w}\|^2$ der Filterkoeffizienten $\tilde{w}$ stellt eine Straffunktion dar, die im Optimierungsergebnis zu hohe Werte für die Filterkoeffizienten $\tilde{w}$ verhindert.

$$C = E\left\{ \left| \tilde{\underline{w}}^{T} \cdot \tilde{\underline{r}} - \tilde{\underline{h}}_{\min}^{T} \cdot \underline{d}_{D} \right|^{2} + \varepsilon \left\| \tilde{\underline{w}} \right\|^{2} \right\} \rightarrow \min_{\underline{w}} \qquad (25)$$

Der Vektor $\tilde{\underline{h}}_{\min}$ der minimal-phasigen Impulsantwort setzt sich gemäß Gleichung (26) aus einem Nullvektor $\underline{0}_{1 \times (L_{AP}-1)}$ der Länge $k_0 = L_{AP}-1$ und der eigentlichen mittels Cepstrum-Funktion ermittelten minimalphasigen Impulsant-wort $\underline{h}_{\min}^{T} = [h_{\min}(0), h_{\min}(1), ..., h_{\min}(L_h - 1)]$ mit einer der Kanallänge $L_h$ entsprechenden Länge zusammen, da das Vorfilter erst nach insgesamt $k_0 = L_{AP}-1$ Abtastzeitpunkten eingeschwungen ist und somit an seinem Ausgang verwertbare Abttastwerte für die Minimierungsfunktion liefert:

$$\tilde{\underline{h}}_{\min} = \left[ \underline{0}_{1 \times (L_{AP}-1)}, \quad \underline{h}_{\min}^{T} \right]^{T} \qquad (26)$$

Der Vektor $\tilde{w}$ der zu ermittelnden Filterkoeffizienten des Vorfilters, das als Polyphasenfilter realisierbar ist, weist gemäß Gleichung (27) eine der Filterlänge $L_{AP}$ entsprechende Länge auf.

$$\tilde{\underline{w}} = \left[ \tilde{w}_0, \tilde{w}_1, \tilde{w}_2, ..., \tilde{w}_{L_{AP}-1} \right]^{T} \qquad (27)$$

Der Empfangsvektor $\tilde{r}$ weist gemäß Gleichung (28) ebenfalls eine der Filterlänge $L_{AP}$ des Vorfilters entspre-chende Länge auf.

$$\tilde{\underline{r}} = \left[ \tilde{r}_0, \tilde{r}_1, \tilde{r}_2, ..., \tilde{r}_{L_{AP}-1} \right]^{T}. \qquad (26)$$

Der Vektor $\underline{d}_D$ der zu sendenden Datensymbol-Sequenz weist somit gemäß Gleichung (27) eine Länge von $L_{AP} + L_h-1$ auf.

$$\underline{d}_D = \left[ d_k, d_{k-1}, d_{k-2}, ..., d_{k-(L_{AP}+L_h-1)} \right]^{T} \qquad (27)$$

Der Empfangsvektor $\tilde{r}$ in der Minimierungsgleichung für die Kostenfunktion $C$ gemäß Gleichung (25) kann durch das Faltungsergebnis der Matrix der Kanalkoeffizienten $\tilde{H}$ gemäß Gleichung (28) mit dem Vektor $\underline{d}_D$ der zu sendenden Datensymbol-Sequenz unter Vernachlässigung des Rauschvektors $\underline{n}$ ersetzt werden. Die daraus entstehende Näherung für die Kostenfunktion $\tilde{C}$ ergibt sich somit gemäß Gleichung (29).

$$
\underline{\tilde{H}} = \begin{pmatrix} h_0 & 0 & \cdots & 0 \\ h_1 & h_0 & \cdots & 0 \\ \vdots & h_1 & \ddots & 0 \\ h_{L_h-1} & \vdots & \ddots & h_0 \\ 0 & h_{L_h-1} & \ddots & h_1 \\ 0 & 0 & \ddots & \vdots \\ 0 & 0 & \ddots & h_{L_h-1} \end{pmatrix} \tag{28}
$$

$$
\check{C} = E\left\{ \left| \underline{d}_D{}^T \cdot \underline{\tilde{H}} \cdot \underline{\tilde{w}} - \underline{\tilde{h}}_{min}{}^T \cdot \underline{d}_D \right|^2 + \varepsilon \| \tilde{w} \|^2 \right\} \to \min_{\underline{w}} \tag{29}
$$

Die Matrix der Kanalkoeffizienten $\underline{\tilde{H}}$ weist die Dimension $(L_h + L_{AP} - 1) x L_{AP}$ auf.

Wird der Übertragungskanal im doppelten Symboltakt abgetastet, so setzt sich das Vorfilter aus zwei parallel geschalteten Vorfiltern mit den Filterkoeffizienten $\underline{\tilde{w}}^{(1)}$ und $\underline{\tilde{w}}^{(2)}$ zusammen. Der Vektor $\tilde{w}$ der zu ermittelnden Filterkoeffizienten eines derartigen Vorfilters ergibt sich ausgehend von Gleichung (27) gemäß Gleichung (30):

$$
\underline{\tilde{w}} = \left[ \underline{\tilde{w}}^{(1)}, \underline{\tilde{w}}^{(2)} \right] = \left[ \tilde{w}_0{}^{(1)}, \tilde{w}_1{}^{(1)}, \tilde{w}_2{}^{(1)}, \ldots, \tilde{w}_{L_{AP}-1}{}^{(1)}, \tilde{w}_0{}^{(2)}, \tilde{w}_1{}^{(2)}, \tilde{w}_2{}^{(2)}, \ldots, \tilde{w}_{L_{AP}-1}{}^{(2)} \right]^T
$$

Der Vektor $\tilde{r}$ des Empfangssignals setzt sich aus den die beiden parallel geschalteten Vorfilter jeweils speisenden Teilvektoren $\underline{\tilde{r}}^{(1)}$ und $\underline{\tilde{r}}^{(2)}$ zusammen und ergibt sich ausgehend von Gleichung (26) gemäß Gleichung (31).

$$
\underline{\tilde{r}} = \left[ \underline{\tilde{r}}^{(1)}, \underline{\tilde{r}}^{(2)} \right] = \left[ \tilde{r}_0{}^{(1)}, \tilde{r}_1{}^{(1)}, \tilde{r}_2{}^{(1)}, \ldots, \tilde{r}_{L_{AP}-1}{}^{(1)}, \tilde{r}_0{}^{(2)}, \tilde{r}_1{}^{(2)}, \tilde{r}_2{}^{(2)}, \ldots, \tilde{r}_{L_{AP}-1}{}^{(2)} \right]^T
$$

Die Matrix der Kanalkoeffizienten $\underline{\tilde{H}}$ setzt sich entsprechend aus den beiden Teilmatrizen $\underline{\tilde{H}}^{(1)}$ und $\underline{\tilde{H}}^{(2)}$ gemäß Gleichung (32) zusammen, wobei die Teilmatrix $\underline{\tilde{H}}^{(1)}$ der Matrix $\underline{\tilde{H}}$ in Gleichung (28) entspricht und die Teilmatrix $\underline{\tilde{H}}^{(2)}$ aus Gleichung (33) hervorgeht.

$$
\underline{\tilde{H}} = \left[ \underline{\tilde{H}}^{(1)}, \underline{\tilde{H}}^{(2)} \right] \tag{32}
$$

$$\underline{\tilde{H}}^{(2)} = \begin{pmatrix} h_{\frac{1}{2}} & 0 & \cdots & 0 \\ h_{\frac{3}{2}} & h_{\frac{1}{2}} & \cdots & 0 \\ \vdots & h_{\frac{3}{2}} & \ddots & 0 \\ h_{L_h-\frac{1}{2}} & \vdots & \ddots & h_{\frac{1}{2}} \\ 0 & h_{L_h-\frac{1}{2}} & \ddots & h_{\frac{3}{2}} \\ 0 & 0 & \ddots & \vdots \\ 0 & 0 & \ddots & h_{L_h-\frac{1}{2}} \end{pmatrix} \qquad (33)$$

Die Näherung der Kostenfunktion unter Vernachlässigung des Rauschvektors $\underline{n}$ ist sinnvoll, da das zu optimierende Vorfilter gemäß Gleichung (2) eine der inversen Übertragungsfunktion $H_{all}(z)^{-1}$ eines Allpasses entsprechende Übertragungsfunktion aufweist und somit einen einem reinen Phasenschieber entsprechenden frequenzinvarianten Amplitudengang besitzt, der das Rauschspektrum nicht verändert, insbesondere den Rauschteppich nicht anhebt.

Die Kostenfunktion $\check{C}$ gemäß Gleichung (29) läßt sich gemäß Gleichung (34) mathematisch umformen:

$$\check{C} = E\left\{ \left| \underline{d}_D^T \cdot \underline{\tilde{H}} \cdot \underline{\tilde{w}} - \underline{\tilde{h}}_{\min}^T \cdot \underline{d}_D \right|^2 + \varepsilon \|\underline{\tilde{w}}\|^2 \right\} =$$

$$= E\left\{ \left( \underline{d}_D^T \cdot \underline{\tilde{H}} \cdot \underline{\tilde{w}} - \underline{\tilde{h}}_{\min}^T \cdot \underline{d}_D \right)^H \left( \underline{d}_D^T \cdot \underline{\tilde{H}} \cdot \underline{\tilde{w}} - \underline{\tilde{h}}_{\min}^T \cdot \underline{d}_D \right) + \varepsilon \|\underline{\tilde{w}}\|^2 \right\} =$$

$$= E\left\{ \left( \underline{\tilde{w}}^H \cdot \underline{\tilde{H}}^H \cdot \underline{d}_D^{\bullet} - \underline{d}_D^H \cdot \underline{\tilde{h}}_{\min}^{\bullet} \right) \left( \underline{d}_D^T \cdot \underline{\tilde{H}} \cdot \underline{\tilde{w}} - \underline{\tilde{h}}_{\min}^T \cdot \underline{d}_D \right) + \varepsilon \|\underline{\tilde{w}}\|^2 \right\} =$$

$$= E\left\{ \underline{\tilde{w}}^H \cdot \underline{\tilde{H}}^H \cdot \underline{d}_D^{\bullet} \cdot \underline{d}_D^T \cdot \underline{\tilde{H}} \cdot \underline{\tilde{w}} - \underline{\tilde{h}}_{\min}^H \underline{d}_D^{\bullet} \cdot \underline{d}_D^T \cdot \underline{\tilde{H}} \cdot \underline{\tilde{w}} \right\} -$$
$$E\left\{ \underline{\tilde{w}}^H \cdot \underline{\tilde{H}}^H \cdot \underline{d}_D^{\bullet} \cdot \underline{d}_D^T \cdot \underline{\tilde{h}}_{\min} + \underline{\tilde{h}}_{\min}^H \underline{d}_D^{\bullet} \cdot \underline{d}_D^T \cdot \underline{\tilde{h}}_{\min} + \varepsilon \|\underline{\tilde{w}}\|^2 \right\} \qquad (34)$$

In Gleichung (34) wird die Rauschkorrelationsmatrix $R_{DD}$ der Eingangsdaten $\underline{d}_D$ gemäß Gleichung (35), die Im Falle eines nicht ideal arbeitenden Quellen-Encoders keine Diagonal-Form hat, eingeführt und führt zu der mathematischen Beziehung für die genäherte Kostenfunktion $\check{C}$ in Gleichung (36).

$$R_{DD} = E\left\{ \underline{d}_D^{\bullet} \cdot \underline{d}_D^T \right\}. \qquad (35)$$

$$\check{C} = \underline{\widetilde{w}}^H \cdot \underline{\widetilde{H}}^H \cdot \underline{R}_{DD} \cdot \underline{\widetilde{H}} \cdot \underline{\widetilde{w}} - \underline{\widetilde{h}}_{\min}^H \underline{R}_{DD} \cdot \underline{\widetilde{H}} \cdot \underline{\widetilde{w}} - \underline{\widetilde{w}}^H \cdot \underline{\widetilde{H}}^H \cdot \underline{R}_{DD} \cdot \underline{\widetilde{h}}_{\min} + \underline{h}_{\min}^H \underline{R}_{DD} \cdot \underline{\widetilde{h}}_{\min} + \varepsilon \|\underline{\widetilde{w}}\|^2$$

$$(36)$$

Die Minimierung der Näherung der Kostenfunktion $\check{C}$ erfolgt nun durch Ableitung der Kostenfunktion nach den gesuchten Filterkoeffizienten $\underline{\widetilde{w}}$ und anschließenden Nullsetzen des Ableitungsergebnissses gemäß Gleichung (37).

$$\frac{\partial \check{C}}{\partial \underline{\widetilde{w}}} = \underline{\widetilde{w}}^H \cdot \underline{\widetilde{H}}^H \cdot \underline{R}_{DD} \cdot \underline{\widetilde{H}} - \underline{\widetilde{h}}_{\min}^H \underline{R}_{DD} \cdot \underline{\widetilde{H}} + \varepsilon \underline{\widetilde{w}}^H \overset{!}{=} 0 \qquad (37)$$

Die gesuchten Filterkoeffizienten $\underline{\widetilde{w}}$ des Vorfilters ergeben sich somit gemäß Gleichung (38):

$$\underline{\widetilde{w}}^H = \underline{\widetilde{h}}_{\min}^H \underline{R}_{DD} \cdot \underline{\widetilde{H}} \cdot \left( \underline{\widetilde{H}}^H \cdot \underline{R}_{DD} \cdot \underline{\widetilde{H}} + \varepsilon \underline{I} \right)^{-1} \qquad (38)$$

In einer zweiten Ausführungsform des erfindungsgemäßen Verfahrens wird in Anlehnung an Gleichung (2) aus der Faltung der Kanalkoeffizienten der Matrix $\underline{H}$ der Übertragungsstrecke mit nicht-minimal-phasiger Übertragungscharakteristik mit den Filterkoeffizienten $\underline{\widetilde{w}}$ des/r Vorfilter die Impulsantwort $\underline{\widetilde{h}}_{\min}$ der Übertragungsstrecke mit minimalphasiger Übertragungscharakteristik gemäß Gleichung (39) berechnet.

$$\underline{\widetilde{h}}_{\min} = \left[ \underline{0}_{1\times(L_{AP}-1)}, \quad \underline{h}_{\min}^T \right]^T = \underline{\widetilde{H}} \cdot \underline{\widetilde{w}} \qquad (39)$$

Die Filterkoeffizienten $\underline{\widetilde{w}}$ des/r Vorfilter ergeben sich nach mathematischer Umformung der Gleichung (39) gemäß Gleichung (40), wobei in die Diagonalelemente der zu ursprünglich zu invertierenden Matrix $\underline{\widetilde{H}}^H \cdot \underline{\widetilde{H}}$ in Analogie zur ersten Ausführungsform ein kleiner reeller Stabilisierungsfaktor $\varepsilon$ zur Stabilisierung der Matrixinversion eingefügt wird.

$$\underline{\widetilde{w}} = (\underline{\widetilde{H}}^H \cdot \underline{\widetilde{H}} + \varepsilon \cdot \underline{I})^{-1} \cdot \underline{\widetilde{H}}^H \cdot \left[ \underline{0}_{1\times(L_{AP}-1)}, \quad \underline{h}_{\min}^T \right]^T \qquad (40)$$

In Gleichung (39) und (40) führen die führenden $L_{AP}$-1 Nullen im Vektor der Impulsantwort $\underline{\widetilde{h}}_{\min}$ zu einer Entscheidungsverzögerung von $D = L_{AP}$-1 Taps. Da die Entscheidungsverzögerung $D$ einen Entwurfsparameter des/r Vorfilters darstellt, kann diese in Abhängigkeit des Übertragungskanals auch eine geringere Anzahl von Taps aufweisen, um auf diese Weise Vorschwinger beim Filtern mit dem/den Vorfilter/n zu vermindern.

Die Impulsantwort $\underline{\widetilde{h}}_{\min}$ der Übertragungsstrecke mit minimal-phasiger Übertragungscharakteristik bei einer um den positiven ganzzahligen Faktor $s$ verringerten Entscheidungsverzögerung $D$ ergibt sich somit gemäß Gleichung (39A).

$$\underline{\widetilde{h}}_{\min} = \left[ \underline{0}_{1\times(L_{AP}-1-s)}, \quad \underline{h}_{\min}^T, \quad \underline{0}_{1\times s} \right]^T = \underline{\widetilde{H}} \cdot \underline{\widetilde{w}} \qquad (39A)$$

In beiden Ausführungsformen des erfindungsgemäßen Verfahren ist eine Matrix-Inversion durchzuführen, für die typischerweise der Trench-Algorithmus benutzt wird. Bei großen Filterlängen $L_{AP}$ des Vorfilters ist die Anwendung des Trench-Algorithmus und ähnlich aufwandsgünstiger Verfahren zur Matrixinversion sehr aufwändig. Im folgenden wird deshalb ein rekursives Verfahren zur Berechnung der Filterkoeffizienten $\underaccent{\tilde}{w}$ des Vorfilters hergeleitet, bei dem die Inversion der Matrix $\underaccent{\tilde}{H}^{H} \cdot \underline{R}_{DD} \cdot \underaccent{\tilde}{H} + \varepsilon \underline{1}$ der erten Ausführungsform und die Inversion der Matrix $\underaccent{\tilde}{H}^{H} \cdot \underaccent{\tilde}{H} + \varepsilon \underline{I}$ der zweiten Ausführungsform des erfindungsgemäßen Verfahrens durch eine Taylor-Reihenentwicklung genähert wird.

Zur Vereinfachung der mathematischen Herleitung wird Gleichung (38) bzw. Gleichung (40) durch Gleichung (41) ersetzt.

$$\underline{d} = \left[ \underline{T} + \sigma^2 \underline{I} \right]^{-1} \cdot \underline{y} = \underline{L} \cdot \underline{y} \qquad\qquad (41)$$

mit

$$\underline{d} \triangleq \underaccent{\tilde}{\underline{w}}^{H}$$

$$\sigma^2 \triangleq \varepsilon$$

und für die erste Ausführungsform des erfindungsgemäßen Verfahrens zur Erzeugung einer minimal-phasigen Übertragungscharakteristik aus einer nicht-minimal-phasigen Übertragungscharakteristik einer Übertragungsstrecke (Gleichung 38):

$$\underline{T} \triangleq \underaccent{\tilde}{\underline{H}}^{H} \cdot \underline{R}_{DD} \cdot \underaccent{\tilde}{\underline{H}}$$

$$\underline{L} \triangleq \left( \underaccent{\tilde}{\underline{H}}^{H} \cdot \underline{R}_{DD} \cdot \underaccent{\tilde}{\underline{H}} + \varepsilon \underline{I} \right)^{-1}$$

$$\underline{y} \triangleq \underaccent{\tilde}{\underline{h}}_{\min}^{H} \underline{R}_{DD} \cdot \underaccent{\tilde}{\underline{H}}$$

bzw. für die zweite Ausführungsform des erfindungsgemäßen Verfahrens zur Erzeugung einer minimal-phasigen Übertragungscharakteristik aus einer nicht-minimal-phasigen Übertragungscharakteristik einer Übertragungsstrecke (Gleichung 40):

$$\underline{T} \triangleq \underaccent{\tilde}{\underline{H}}^{H} \cdot \underaccent{\tilde}{\underline{H}}$$

$$\underline{L} \triangleq \left( \underaccent{\tilde}{\underline{H}}^{H} \cdot \underaccent{\tilde}{\underline{H}} + \varepsilon \underline{I} \right)^{-1}$$

$$\underline{y} \triangleq \underaccent{\tilde}{\underline{h}}_{\min}^{H} \cdot \underaccent{\tilde}{\underline{H}}$$

Die invertierte Matrix $\underline{L}$ wird durch eine Taylor-Reihe $\hat{\underline{L}}$ in der allgemeinen Form gemäß Gleichung (42) genähert.

$$\underline{\hat{L}} = \sum_{j=0}^{N_s-1} w_j \cdot \underline{\widetilde{X}}^{\,j} \qquad (42)$$

Die Taylor-Reihe besitzt die Ordnung $N_s$-1. Die Größen $w_j$ sind die jeweiligen Gewichtungsfaktoren und die Größen $\underline{\widetilde{X}}$ sind die jeweiligen Faktoren der Taylor-Reihe. Die Taylor-Reihen-Entwicklung für eine zu invertierende Matrix ergibt sich aus Gleichung (43), wobei $\alpha$ ein reeller Normalisierungsfaktor zur Konvergenz der zu entwickelnden Taylor-Reihe ist und $\lambda_i(\underline{X})$ die Eigenwerte der Matrix $\underline{X}$ sind.

$$\alpha\left(\underline{X} + \underline{I}\right)^{-1} = \alpha\sum_{j=0}^{\infty}\left(-\underline{X}\right)^{j} \quad \forall \underline{X}, i \ \left|\lambda_i(\underline{X})\right| < 1 \qquad (43)$$

Der Zusammenhang zwischen der invertierten Matrix $\underline{\hat{L}}$ und der Matrix $\underline{X}$ ergibt sich gemäß Gleichung (44) durch Gleichsetzen der linke Seite von Gleichung (43) mit der linken Seite von Gleichung (41).

$$\underline{X} = \alpha \cdot \underline{L}^{-1} - \underline{I} = \alpha \cdot \underline{T} + \alpha \cdot \sigma^2 \cdot \underline{I} - \underline{I} \qquad (44)$$

Die Näherung $\underline{\hat{L}}$ für die invertierte Matrix $\underline{L}$ ergibt sich folglich gemäß Gleichung (45) durch Einsetzen der mathematischen Beziehung für die Matrix $\underline{X}$ aus Gleichung (44) in die Taylor-Reihen-Entwicklung von Gleichung (43), sofern die Taylor-Reihe nach insgesamt $N_s$ Faktoren abgebrochen wird.

$$\underline{L} = \left(\underline{R} + \sigma^2\underline{I}\right)^{-1} \approx \underline{\hat{L}} = \alpha\sum_{j=0}^{N_s-1}\left(-\left(\alpha\underline{T} + \alpha\sigma^2\underline{I} - \underline{I}\right)\right)^{j} \qquad (45)$$

Somit kann die Ausgangsgleichung (41) gemäß Gleichung (46) genähert werden.

$$\underline{d} = \underline{L} \cdot \underline{y} \approx \underline{\hat{L}} \cdot \underline{y} = \alpha\sum_{j=0}^{N_s-1}\left(-\underline{X}\right)^{j} \cdot \underline{y} = \alpha\sum_{j=0}^{N_s-1}\left(-\left(\alpha\underline{T} + \alpha\sigma^2\underline{I} - \underline{I}\right)\right)^{j} \cdot \underline{y} \qquad (46)$$

Somit sind die einzelnen Gewichtungsfaktoren $w_j$ aus Gleichung (42) identisch und entsprechen dem reellen Normalisierungsfaktor $\alpha$.

Nach dem Horner-Schema läßt sich für Gleichung (46) eine rekursive Berechnungsformel für die Rekursionsvariable $\underline{d}^{(i)}$ gemäß Gleichung (47A) entwickeln, die im ersten Rekursionsschritt mit der Berechnung nach Gleichung (47B) durch Initialisierung der Rekursionsvariable $\underline{d}^{(1)}$ gestartet wird.

$$\underline{d}^{(i+1)} = \alpha\,\underline{y} - \underline{X} \cdot \underline{d}^{(i)} \qquad (47A)$$

$$\underline{d}^{(1)} = \alpha\,\underline{y} \qquad (47B)$$

Der für die Rekursionsformeln (47A) und (47B) benötigte Normalisierungsfaktor $\alpha$ läßt sich aus der Konvergenzbedingung $|\lambda_i(\underline{X})|<1$ für die Taylor-Reihe in Gleichung (43) ermitteln. Da die einzelnen Eigenwerte $\lambda_i(\underline{X})$ der Matrix $\underline{X}$ schwer ermittelbar sind, wird einzig der maximale Eigenwert $\lambda_{max}(\underline{X})$ der Matrix $\underline{X}$ gemäß Gleichung (48) geschätzt. Unter Berücksichtigung von Gleichung (44) kann Gleichung (48) nach Gleichung (48a) übergeführt werden. Da $\lambda_{max}$ ein für die Matrix $\underline{R}+\sigma^2 I$ gesuchter Eigenwert ist, hat die Matrix $\alpha\underline{R} + \alpha\sigma^2 I$ den Eigenwert $\alpha \cdot \lambda_{max}$ und der Normalisierungsfaktor $\alpha$ kann somit gemäß Gleichung (48b) vor die Funktion $\lambda_{max}(.)$ zur Ermittlung des maximalen Eigenwerts gezogen werden. Da die Einheitsmatrix $\underline{I}$ in Gleichung (48) den gesuchten maximalen Eigenwert der Matrix $\alpha\underline{R}+\alpha\sigma^2 \underline{I}$ um den Faktor 1 reduziert, kann dieser Faktor 1 gemäß Gleichung (48b) vor die Funktion $\lambda_{max}(.)$ zur Ermittlung des maximalen Eigenwerts gezogen werden. Aus gleichem Grund kann der Faktor $\sigma^2$ der Matrix $\sigma^2 I$ gemäß Gleichung (48c) vor die Funktion $\lambda_{max}(.)$ zur Ermittlung des maximalen Eigenwerts gezogen werden. Die Maximalabschätzung $\alpha\lambda_{max}(\underline{R} + \sigma^2 I) = 2$ in Gleichung (48b) wird zur Bestimmung von Gleichung (48c) benutzt.

$$\left| \lambda_{max}\left( \underline{X} \right) \right| \quad < \quad 1 \tag{48}$$

$$\left| \lambda_{max}\left( \alpha\underline{T} + \alpha\sigma^2 \underline{I} - \underline{I} \right) \right| \quad < \quad 1 \tag{48a}$$

$$\left| 1 - \alpha\lambda_{max}\left( \underline{T} + \sigma^2 \underline{I} \right) \right| \quad < \quad 1 \tag{48b}$$

$$\frac{2}{\left| \lambda_{max}\left( \underline{T} + \sigma^2 \underline{I} \right) \right|} = \frac{2}{\left| \lambda_{max}\left( \underline{T} \right) + \sigma^2 \right|} \quad > \quad \alpha \tag{48c}$$

Da die Autokorrelationsmatrix $\underline{R}_{DD}$ und auch die Matrizen der Kanalkoeffizienten $\tilde{\underline{H}}$ bzw. $\tilde{\underline{H}}^H$ hermitsche und positv-definite Matrizen sind, so ist auch die Matrix $\underline{T} \triangleq \tilde{\underline{H}}^H \cdot \underline{R}_{DD} \cdot \tilde{\underline{H}}$ eine hermitsche und positv-definite Matrix und somit sind deren Eigenwerte $\lambda_i(\underline{T})$ positiv reell. Für den maximalen Eigenwert $\lambda_{max}(\underline{T})$ und minimalen Eigenwert $\lambda_{min}(\underline{T})$ der Matrix $\underline{T}$ ergibt sich folglich die in Ungleichung (49) dargestellte Beziehung.

$$0 \le \lambda_{min}\left( \underline{T} \right) \le\le \lambda_{max}\left( \underline{T} \right) \tag{49}$$

Während der maximale Eigenwert $\lambda_{max}(\underline{T})$ der Matrix $\underline{T}$ gemäß Gleichung (48c) abgeschätzt werden kann, kann der minimale Eigenwert $\lambda_{min}(\underline{T})$ der Matrix $\underline{T}$ gemäß der Konvergenzbedingung der Taylor-Reihe in Gleichung (43) abgeschätzt werden, so dass die Abschätzungen für $\lambda_{min}(\underline{T})$ und $\lambda_{max}(\underline{T})$ in Gleichung (45) noch gemäß Gleichung (50) verfeinert werden können.

$$1 \le \lambda_{min}\left( \alpha\left( \underline{T} + \sigma^2 \underline{I} \right) \right) \le\le \lambda_{max}\left( \alpha\left( \underline{T} + \sigma^2 \underline{I} \right) \right) < 2 \tag{50}$$

Die beste Konvergenz der Taylor-Reihe wird erzielt, wie hier nicht näher ausgeführt wird, wenn alle Eigenwerte $\lambda_i(\alpha(\underline{T}+\sigma^2 I))$ der Matrix $\alpha(\underline{T} + \sigma^2 I)$ einen Wert bei 2 besitzen. Der optimale Normalisierungsfaktor $\alpha_{opt}$ ergibt sich in diesem Fall gemäß Gleichung (51).

$$\alpha_{opt} \quad = \quad \frac{2}{\lambda_{min}\left(\underline{T}+\sigma^2\underline{I}\right)+\lambda_{max}\left(\underline{T}+\sigma^2\underline{I}\right)} =$$

$$= \quad \frac{2}{\lambda_{min}\left(\underline{T}\right)+\lambda_{max}\left(\underline{T}\right)+2\sigma^2} \tag{51}$$

Die für die Ermittlung des optimalen Normalisierungsfaktors $\alpha_{opt}$ erforderlichen minimalen und maximalen Eigenwerte $\lambda_{min}(\underline{T})$ und $\lambda_{max}(\underline{T})$ der Matrix $\underline{T}$ können grob gemäß Gleichung (52) und (53) geschätzt werden.

$$0 \le \lambda_{min}\left(\underline{T}\right) \tag{52}$$

$$\lambda_{max}\left(\underline{T}\right) \le spur(\underline{T}) \tag{53}$$

Für eine feinere Schätzung der minimalen und maximalen Eigenwerte $\lambda_{min}(\underline{T})$ und $\lambda_{max}(\underline{T})$ der Matrix $\underline{T}$ werden die Gerschgorin-Kreise benutzt. Gemäß dem Gerschgorin-Theorem liegen alle Eigenwerte $\lambda_i(\underline{T})$ einer $V \times V$-dimensinalen Matrix $\underline{T}$ jeweils innerhalb eines der $V$ Gerschgorin-Kreise in der komplexen $\lambda$-Ebene, wobei der Mittelpunkt jedes Gerschgorin-Kreises jeweils einem der $V$ Diagonalelemente $t_{mm}$ der Matrix $\underline{T}$ entspricht. Der Radius jedes Gerschgorin-Kreises ergibt sich aus der Summe der Beträge der übrigen Elemente $t_{mn}$ der jeweiligen Zeile $m$ der Matrix $\underline{T}$. Für jeden Eigenwert $\lambda_i(\underline{T})$ der Matrix $\underline{T}$ ergibt sich somit die in Ungleichung (54) dargestellte mathematische Beziehung.

$$\left|t_{mm} - \lambda_i(\underline{T})\right| \le \sum_{n,n \ne m}\left|t_{mn}\right| \tag{54}$$

Eine obere Grenze für den Eigenwert $\lambda_i(\underline{T})$ ergibt sich ausgehend von Gleichung (54) somit gemäß Gleichung (55).

$$\left|\lambda_i(\underline{T})\right| \le \sum_n\left|t_{mn}\right| \tag{55}$$

Gemäß Gleichung (56) ergibt sich somit eine Abschätzung für den minimalen Eigenwert $\lambda_{min}(\underline{T})$ der Matrix $\underline{T}$ ausgehend von Gleichung (54) unter Einhaltung der Voraussetzung einer Nicht-Negativität des Eigenwertes. Gemäß Gleichung (57) ergibt sich eine Abschätzung für den minimalen Eigenwert $\lambda_{max}(\underline{T})$ der Matrix $\underline{T}$ somit ausgehend von Gleichung (55).

$$\lambda_{min}(\underline{T}) \quad \ge \quad \max\left\{\min_{m \in (1,V)}\left\{t_{mm} - \sum_{n,n \ne m}\left|t_{mn}\right|\right\}, 0\right\} \tag{56}$$

$$\lambda_{max}(\underline{T}) \quad \le \quad \max_{m \in (1,V)}\left\{\sum_n\left|t_{mn}\right|\right\} \tag{57}$$

Aus der Faltung der Kanalkoeffizienten der Matrix $\widetilde{\underline{H}}$ der Übertragungsstrecke mit nicht-minimal-phasiger Übertragungscharakteristik gemäß Gleichung (28) oder (32) i.V.m. (33) mit den gemäß Gleichung (38) oder Gleichung (40) berechneten Filterkoeffizienten $\widetilde{\underline{w}}$ des/r Vorfilter kann gemäß Gleichung (58) die Impulsantwort $\underline{\tilde{h}}_{\min}$ der Übertragungsstrecke mit minimal-phasiger Übertragungscharakteristik berechnet werden.

$$\underline{\tilde{h}}_{\min} = \left[ \underline{0}_{1\times(L_{AP}-1)}, \quad \underline{h}_{\min}^{T} \right]^{T} = \widetilde{\underline{H}} \cdot \underline{\tilde{w}} \qquad (58)$$

Auf der Basis dieser mathematischen Herleitungen werden im Folgenden zuerst die beiden Ausführungsformen der erfindungsgemäßen Übertragungsstrecke und daraufhin das erfindungsgemäße Verfahren zur Erzeugung einer minimal-phasigen Übertragungscharakteristik aus einer nicht-minimal-phasigen Übertragungscharakteristik einer Übertragungsstrecke anhand der Fig. 3, 4 und 5 erläutert.

Die erste Ausführungsform der erfindungsgemäßen Übertragungsstrecke beinhaltet die Abtastung des Empfangssignals im vollen Symboltakt. Die erste Ausführungsform der erfindungsgemäßen Übertragungsstrecke in Fig. 3 besteht aus einem Senderfilter 1 mit der Impulsantwort $u_T(t)$, das von der Sendesymbol-Sequenz $\sum_{\underline{k}} d_k \cdot \delta(t - k \cdot T)$ beaufschlagt wird, dem nachfolgenden eigentlichen Übertragungskanal 2 mit der Kanalimpulsantort $g(r,t)$, der additiven Überlagerung des Übertragungssignals mit dem Störsignal $z(t)$ - üblicherweise einem Rauschsignal - an der "symbolischen Additionsstelle" 3, dem nachfolgenden Empfangsfilter 4 mit der Impulsantwort $u_R(t)$, dem Abtaster 5 zur Abtastung des Empfangssignals $r(t)$ mit der vollen Symbolrate $\dfrac{1}{T}$ und dem nachfolgenden Vorfilter 6 mit der Impulsantwort $g_{VF}(t)$. Der erfindungsgemäßen Übertragungsstrecke folgt ein Detektor 7 zur Entzerrung und Ermittlung von Schätzwerten $\hat{d}_k$ der gesendeten Datensymbole $d_k$.

Als ursprünglich nicht-minimal-phasige Übertragungsstrecke 8 wird die Kaskade aus Senderfilter 1, eigentlichem Übertragungskanal 2 und Empfangsfilter 4 betrachtet. Als erfindungsgemäße minimal-phasige Übertragungsstrecke 9 wird die Kaskade aus Senderfilter 1, eigentlichem Übertragungskanal 2, Empfangsfilter 4 und Vorfilter 6 betrachtet.

Die zweite Ausführungsform der erfindungsgemäßen Übertragungsstrecke beinhaltet die Abtastung des Empfangssignals im $n$-fachen Symboltakt. Das in Fig. 4 dargestellte Beispiel einer zweiten Ausführungsform der erfindungsgemäßen Übertragungsstrecke ergibt sich bei Abtastung des Empfangssignals mit doppeltem Symboltakt $\dfrac{2}{T}$. Zur ersten Ausführungsform der erfindungsgemäßen Übertragungsstrecke identische Elemente der zweiten Ausführungsform weisen ein identisches Bezugszeichen auf und werden im Einzelnen nicht mehr erläutert. Die zweite Ausführungsform 9' der erfindungsgemäßen Übertragungsstrecke weist im Anschluß an den Abtaster 5 einen ersten Umschalter 10 zur abwechselnden Verteilung der Abtastwerte des abgetasteten Empfangssignals $r(k)$ an die Eingänge der beiden parallel geschalteten Vorfilter $6^{(1)}$ und $6^{(2)}$ auf, wo sie als Empfangssignale $r(k)^{(1)}$ und $r(k)^{(2)}$ im vollen Symboltakt $\dfrac{1}{T}$ vorliegen. Die an den Ausgängen der beiden parallel geschalteten Vorfilter $6^{(1)}$ und $6^{(2)}$ anliegenden vorgefilterten Empfangssignale $r'(k)^{(1)}$ und $r'(k)^{(2)}$ werden über einen anschließenden zweiten Umschalter 11 zu einem einzigen vorgefilterten Empfangssignal $r'(k)$ im doppelten Symboltakt $\dfrac{2}{T}$ am Eingang des Detektors 7 gebündelt.

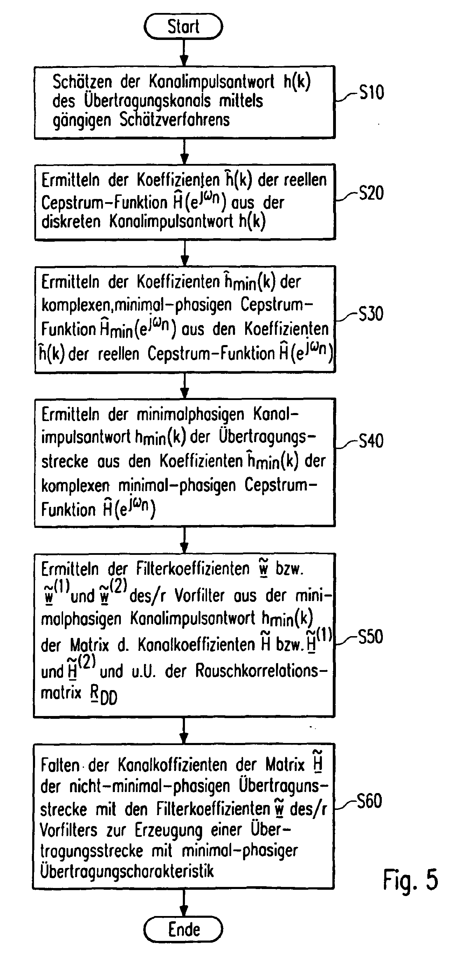

Die erste und zweite Ausführungsform des erfindungsgemäßen Verfahrens zur Erzeugung einer minimalphasigen Übertragungscharakteristik aus einer nicht-minimal-phasigen Übertragungscharakteristik eines Übertragungskanals in Fig. 5 beginnt in Verfahrensschritt S10 mit dem Schätzen der Kanalimpulsantwort $h(k)$ der Übertragungsstrecke mit nicht-minimal-phasiger Übertragungscharakteristik 8 zu den Abtastzeitpunkten $k=0,1,...,L_h-1$ bei Abtastung im vollen Symboltakt $\dfrac{1}{T}$ und zusätzlich zu den Abtastzeitpunkten $k = \dfrac{1}{2}, \dfrac{3}{2}, ..., L_h - \dfrac{1}{2}$ bei Abtastung im doppelten Symboltakt $\dfrac{2}{T}$ (bei Abtastung im $n$-fachen Symboltakt $\dfrac{n}{T}$ wird die Kanalimpulsantwort $h(k)$ zusätzlich zu den Abtastzeitpunkten

$$k = \frac{1}{n}, \frac{2}{n}, ..., L_h - \frac{1}{n}$$ geschätzt). Als Schätzverfahren können alle gängigen Schätzverfahren - beispielsweise Least-Squares-Verfahren - verwendet werden.

Im darauffolgenden Verfahrensschritt S20 wird gemäß Gleichung (19) die diskrete Übertragungsfunktion $H$ $(e^{j\omega}{}_n)$ der Übertragungsstrecke mit nicht-minimal-phasiger Übertragungscharakteristik 8 mittels diskreter Fourier-Transformation für die diskreten Kreisfrequenzen $\omega_n$ mit n=0,1,..., M-1 ermittelt. Auf der Basis der ermittelten diskreten Übertragungsfunktion $H(e^{j\omega}{}_n)$ wird die reelle, nicht-minimal-phasige Cepstrum-Funktion $\hat{H}(e^{j\omega n})$ gemäß Gleichung (20) berechnet. Daraufhin erfolgt die Ermittlung der Koeffizienten $\hat{h}(k)$ der reellen, nicht-minimal-phasigen Cepstrum-Funktion $\hat{H}(e^{j\omega n})$ gemäß Gleichung (21).

Im darauffolgenden Verfahrensschritt werden im cepstralen Bereich aus den Koeffizienten $\hat{h}(k)$ der reellen, nicht-minimal-phasigen Cepstrum-Funktion $\hat{H}(e^{j\omega n})$ die Koeffizienten $\hat{h}_{min}(k)$ der komplexen, minimal-phasigen Cepstrum-Funktion $\hat{H}_{min}(e^{j\omega}{}_n)$ gemäß Gleichung (22) berechnet.

Im nächsten Verfahrensschritt S40 wird gemäß Gleichung (23) aus den Koeffizienten $\hat{h}_{min}(k)$ der komplexen, minimal-phasigen Cepstrum-Funktion $\hat{H}_{min}(e^{j\omega}{}_n)$ die komplexe, minimal-phasige Cepstrum-Funktion $\hat{H}_{min}(e^{j\omega}{}_n)$ mittels diskreter Fourier-Transformation für die diskreten Kreisfrequenzen $\omega_n$ mit n=0,1,..., M-1 und daraus mittels Exponentialfunktion die diskrete minimal-phasige Übertragungsfunktion $H_{min}(e^{j\omega}{}_n)$ ermittelt. Schließlich erfolgt in Verfahrensscritt S40 die Berechnung der diskreten, minimal-phasigen Impulsantwort $h_{min}(k)$ für die diskreten Zeitpunkte k=0,1, ... , M-1 aus der diskreten minimal-phasigen Übertragungsfunktion $H_{min}(e^{j\omega}{}_n)$ mittels diskreter Fourier-Transformation gemäß Gleichung (24).

Im nächsten Verfahrensschritt S50 werden die Filterkoeffizienten $\tilde{w}$ des/r Vorfilters 6 bzw. $6^{(1)}, 6^{(2)}, ... , 6^{(n)}$ für die erste Ausführungsform des erfindungsgemäßen Verfahrens gemäß Gleichung (38) und für die zweite Ausführungsform des erfindungsgemäßen Verfahrens gemäß Gleichung (40) ermittelt, wobei der Vektor der Filterkoeffizienten $\tilde{w}$ bei Abtastung im vollen Symboltakt $\dfrac{1}{T}$ gemäß Gleichung (27) eine Länge $L_{AP}$, bei Abtastung im doppelten Symboltakt $\dfrac{2}{T}$ gemäß Gleichung (30) eine Länge $2 \cdot L_{AP}$ und bei Abtastung im $n$-fachen Symboltakt $\dfrac{n}{T}$ eine Länge von $n \cdot L_{AP}$ aufweist.

Der hierfür erforderliche Vektor $\tilde{h}_{min}$ der minimalphasigen Impulsantwort setzt sich gemäß Gleichung (26) aus dem Nullvektor $\underline{0}_{1 \times (L_{AP}-1)}$ der Länge $k_0 = L_{AP} - 1$ und der eigentlichen mittels Cepstrum-Funktion ermittelten minimalphasigen Impulsantwort $\underline{h}_{min}^T = [h_{min}(0), h_{min}(1), ..., h_{min}(L_h - 1)]$ mit einer der Kanallänge $L_h$ entsprechenden Länge zusammen.

Die für die Berechnung der Filterkoeffizienten $\tilde{w}$ der ersten Ausführungsform des erfindungsgemäßen Verfahrens erforderliche Rauschkorrelationsmatrix $R_{DD}$ wird gemäß Gleichung (35) aus dem Erwartungswert der Eingangsdaten $\underline{d}_D$ ermittelt.

Die ebenfalls für die Berechnung der Filterkoeffizienten $\tilde{w}$ erforderliche Matrix der Kanalkoeffizienten $\tilde{\underline{H}}$ setzt sich gemäß Gleichung (28) aus den in Verfahrensschritt S10 geschätzten Werten der Kanalimpulsantwort $h(k)$ der Übertragungsstrecke mit nicht-minimal-phasiger Übertragungscharakteristik 8 zu den Abtastzeitpunkten $k=0,1,...,L_h-1$ bei Abtastung im vollen Symboltakt $\dfrac{1}{T}$ zusammen. Bei Abtastung im doppelten Symboltakt $\dfrac{2}{T}$ setzt sich die Matrix der Kanalkoeffizienten $\tilde{\underline{H}}$ aus den beiden Teilmatrizen $\tilde{\underline{H}}^{(1)}$ und $\tilde{\underline{H}}^{(2)}$ gemäß Gleichung (32) und (33) zusammen. Bei Abtastung im $n$-fachen Symboltakt $\dfrac{n}{T}$ setzt sich die Matrix der Kanalkoeffizienten $\tilde{\underline{H}}$ aus den insgesamt $n$ Teilmatrizen $\tilde{\underline{H}}^{(1)}$ bis $\tilde{\underline{H}}^{(n)}$ zusammen, die Abtastwerte der Kanalimpulsantwort $h(k)$ zusätzlich zu den Abtastzeitpunkten $$k = \frac{1}{n}, \frac{2}{n}, ..., L_h - \frac{1}{n}$$ aufweisen.

Für den schließlich noch benötigten Stabilisierungsfaktor $\varepsilon$ ist ein kleiner reeller Wert auszuwählen.

Im abschließenden Verfahrensschritt S60 wird die Matrix mit Filterkoeffizienten $\tilde{\underline{H}}$ der Übertragungsstrecke mit nicht-minimal-phasiger Übertragungscharakteristik mit dem in Verfahrensschritt S50 ermittelten Vektor $\tilde{w}$ der Filterkoeffizienten des/r Vorfilters 6 bzw. $6^{(1)}, 6^{(2)}, ... , 6^{(n)}$ gemäß Gleichung (58) zur Erzeugung der Impulsantwort $\underline{h}_{min}$ der Übertragungsstrecke mit minimal-phasiger Übertragungscharakteristik multipliziert.

Die für die Berechnung der Filterkoeffizienten $\tilde{w}$ in Verfahrensschritt S50 erforderliche Matrixinversion kann beispielsweise mit dem üblichen Trench-Verfahren durchgeführt werden. Bei großen Filterlängen $L_{AP}$ des/r Vorfilter 6

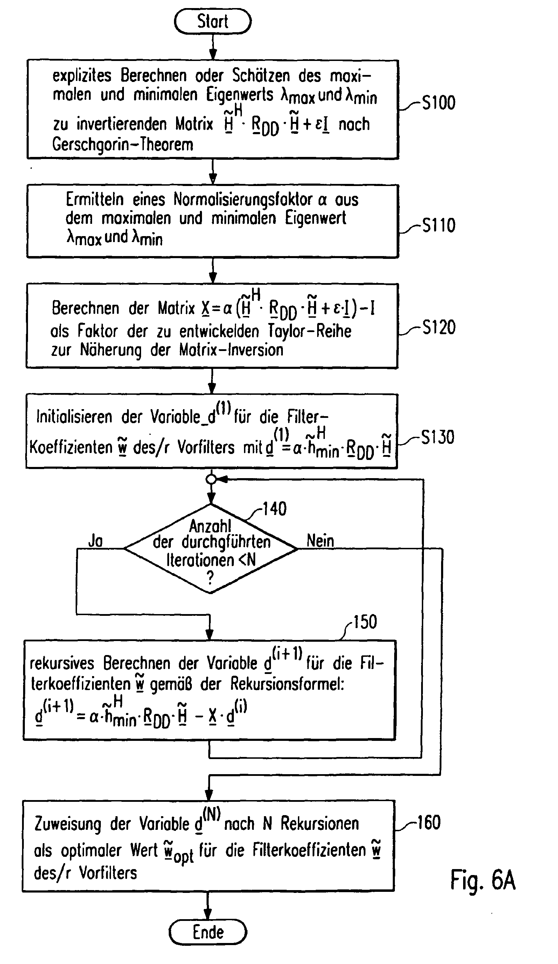

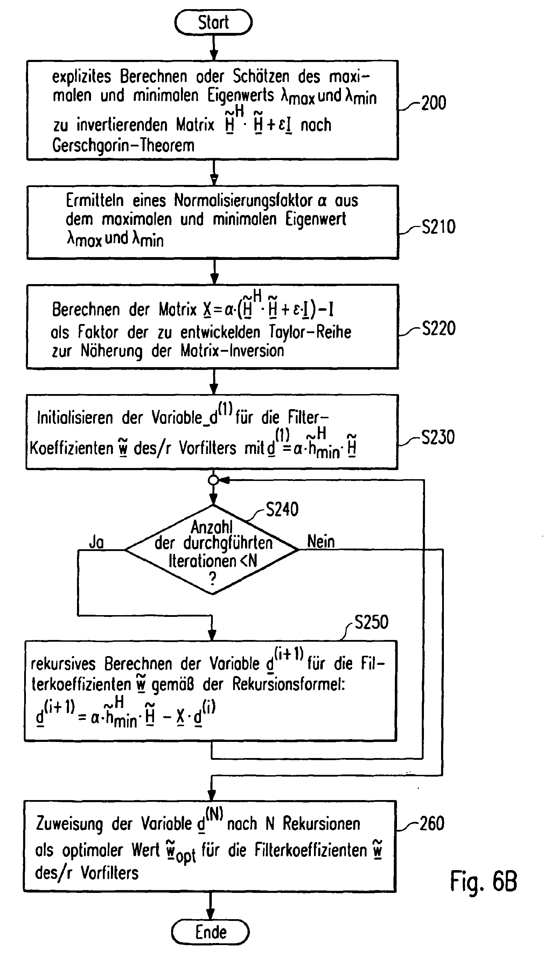

bzw. $6^{(1)}, 6^{(2)}, ... , 6^{(n)}$ ist der Trench-Algorithmus zu aufwändig, so dass im Folgenden anhand von Fig. 6A zur Anwendung in der ersten Ausführungsform des erfindungsgemäßen Verfahrens zur Erzeugung einer minimal-phasigen Übertragungscharakteristik aus einer nicht-minimal-phasigen Übertragungscharakteristik einer Übertragungsstrecke und anhand von Fig. 6B zur Anwendung in der ersten Ausführungsform des erfindungsgemäßen Verfahrens zur Erzeugung einer minimal-phasigen Übertragungscharakteristik aus einer nicht-minimal-phasigen Übertragungscharakteristik einer Übertragungsstrecke ein rekursives Verfahren zur Berechnung der Filterkoeffizienten $\widetilde{w}$ des/r Vorfilters 6 bzw. $6^{(1)}$, $6^{(2)}, ... , 6^{(n)}$ erläutert wird, bei der die Inversion der Matrix durch eine Taylor-Reihen-Entwicklung genähert wird.

Im ersten Verfahrensschritt S100 des rekursiven Verfahrens zur Berechnung der Filterkoeffizienten $\widetilde{w}$ mit Anwendung in der ersten Ausführungsform des erfindungsgemäßen Verfahrens zur Erzeugung einer minimal-phasigen Übertragungscharakteristik aus einer nicht-minimal-phasigen Übertragungscharakteristik einer Übertragungsstrecke in Fig. 6A werden der maximale und minimale Eigenwert $\lambda_{min}$ und $\lambda_{max}$ der zu invertierenden Matrix $\underline{\widetilde{H}}^H \cdot \underline{R}_{DD} \cdot \underline{\widetilde{H}} + \varepsilon \underline{I}$ ermittelt. Dies kann entweder durch explizite Berechnung oder durch Schätzung erfolgen. Bei einer groben Schätzung ergibt sich für den minimalen und maximalen Eigenwert $\lambda_{min}$ und $\lambda_{max}$ der zu invertierenden Matrix $\underline{\widetilde{H}}^H \cdot \underline{R}_{DD} \cdot \underline{\widetilde{H}} + \varepsilon \underline{I}$ die Abschätzung gemäß Gleichung (52) und (53) zuzüglich dem Stabilisierungsfaktor $\varepsilon$, wobei die dabei verwendete Matrix $\underline{T}$ gemäß Gleichung (41) der Teilmatrix $\underline{\widetilde{H}}^H \cdot \underline{R}_{DD} \cdot \underline{\widetilde{H}}$ der zu invertierenden Matrix $\underline{\widetilde{H}}^H \cdot \underline{R}_{DD} \cdot \underline{\widetilde{H}} + \varepsilon \underline{I}$ entspricht. Für eine genauere Schätzung nach dem Gerschgorin-Theorem ergibt sich für den minimalen und maximalen Eigenwert $\lambda_{min}$ und $\lambda_{max}$ der zu invertierenden Matrix $\underline{\widetilde{H}}^H \cdot \underline{R}_{DD} \cdot \underline{\widetilde{H}} + \varepsilon \underline{I}$ die Abschätzung nach Gleichung (56) und (57) zuzüglich dem Stabilisierungsfaktor $\varepsilon$. Die dabei verwendete *Größe* $t_{mm}$ entspricht dem Diagonalelement in der $m$-ten Spalte und $m$-ten Zeile der Matrix $\underline{T}$, während die verwendete Größe $t_{mn}$ einem Nicht-Diagonalelement in der $m$-ten Zeile der Matrix $\underline{T}$ entspricht.

Im darauffolgenden Verfahrensschritt S110 wird ein Normalisierungsfaktor $\alpha$ für die Rekursion gemäß Gleichung (51) aus den in Verfahrensschritt S100 ermittelten minimalen und maximalen Eigenwert $\lambda_{min}$ und $\lambda_{max}$ der zu invertierenden Matrix $\underline{\widetilde{H}}^H \cdot \underline{R}_{DD} \cdot \underline{\widetilde{H}} + \varepsilon \underline{I}$ berechnet.

Der nächste Verfahrensschritt S120 beinhaltet die Berechnung der Matrix $\underline{X}$ als Faktor der für die Näherung der Matrixinversion zu entwickelnden Taylor-Reihe gemäß Gleichung (44) in Abhängigkeit des Normalisierungsfaktors $\alpha$, der zu invertierenden Matrix $\underline{\widetilde{H}}^H \cdot \underline{R}_{DD} \cdot \underline{\widetilde{H}} + \varepsilon \underline{I}$ und der Einheitsmatrix $\underline{I}$.

Im darauffolgenden Verfahrensschritt S130 wird die Rekursionsvariable $\underline{d}^{(1)}$ zum Rekursionsschritt $i$=1 für die rekursive Berechnung des Vektors $\widetilde{w}$ des/r Vorfilters 6 bzw. $6^{(1)}, 6^{(2)}, ... , 6^{(n)}$ gemäß Gleichung (47B) i.V.m. Gleichung (41) initialisiert.

Im nächsten Verfahrensschritt S140 wird überprüft, ob die Anzahl der bereits durchgeführten Rekursionen $i$ unterhalb der maximalen Anzahl $N$ von durchzuführenden Rekursionen liegt und somit ein weiterer Rekursionsschritt durchzuführen ist.

Liegt die Anzahl $i$ der bereits durchgeführten Rekursionen unterhalb der maximalen Anzahl $N$ von durchzuführenden Rekursionen, so wird im nächsten Verfahrensschritt S150 die Rekursionsvariable $\underline{d}^{(i+1)}$ zum Rekursionsschritt $i$+1 für die rekursive Berechnung des Vektors $\widetilde{w}$ der Filterkoeffizienten des/r Vorfilters 6 bzw. $6^{(1)}, 6^{(2)}, ... , 6^{(n)}$ rekursiv aus der Rekursionsvariable $\underline{d}^{(i)}$ zum vorherigen Rekursionsschritt $i$, der Matrix $\underline{X}$ und der in Verfahrensschritt S130 vorinitialisierten Rekursionsvariable $\underline{d}^{(1)}$ gemäß Gleichung (47A) i.V.m. Gleichung (41) berechnet.

Entspricht die Anzahl $i$ der bereits durchgeführten Rekursionen der maximalen Anzahl $N$ von durchzuführenden Rekursionen, so wird in Verfahrensschritt S160 die nach insgesamt $N$ durchgeführten Rekursionen rekursiv berechnete Rekursionsvariable $\underline{d}^{(N)}$ als optimierter Wert $\widetilde{w}_{opt}$ für die Filterkoeffizienten $\widetilde{w}$ des/r Vorfilters 6 bzw. $6^{(1)}, 6^{(2)}, ..., 6^{(n)}$ identifiziert.

Im ersten Verfahrensschritt S200 des rekursiven Verfahrens zur Berechnung der Filterkoeffizienten $\widetilde{w}$ mit Anwendung in der zweiten Ausführungsform des erfindungsgemäßen Verfahrens zur Erzeugung einer minimal-phasigen Übertragungscharakteristik aus einer nicht-minimal-phasigen Übertragungscharakteristik einer Übertragungsstrecke in Fig. 6B werden der maximale und minimale Eigenwert $\lambda_{min}$ und $\lambda_{max}$ der zu invertierenden Matrix $\underline{\widetilde{H}}^H \cdot \underline{\widetilde{H}} + \varepsilon \underline{I}$ ermittelt. Dies kann entweder durch explizite Berechnung oder durch Schätzung erfolgen. Bei einer groben Schätzung ergibt sich für den minimalen und maximalen Eigenwert $\lambda_{min}$ und $\lambda_{max}$ der zu invertierenden Matrix $\underline{\widetilde{H}}^H \cdot \underline{\widetilde{H}} + \varepsilon \underline{I}$ die Abschätzung gemäß Gleichung (52) und (53) zuzüglich dem Stabilisierungsfaktor $\varepsilon$, wobei die dabei verwendete Matrix $\underline{T}$ gemäß Gleichung (41) der Teilmatrix $\underline{\widetilde{H}}^H \cdot \underline{\widetilde{H}}$ der zu invertierenden Matrix $\underline{\widetilde{H}}^H \cdot \underline{\widetilde{H}} + \varepsilon \underline{I}$ entspricht. Für eine genauere Schätzung nach dem Gerschgorin-Theorem ergibt sich für den minimalen und maximalen Eigenwert $\lambda_{min}$ und $\lambda_{max}$ der zu invertierenden Matrix $\underline{\widetilde{H}}^H \cdot \underline{\widetilde{H}} + \varepsilon \underline{I}$ die Abschätzung nach Gleichung (56) und (57) zuzüglich dem Stabilisierungsfaktor $\varepsilon$. Die dabei verwendete Größe $t_{mm}$ entspricht dem Diagonalelement in der $m$-ten Spalte und $m$-ten Zeile der Matrix $\underline{T}$, während die verwendete Größe $t_{mn}$ einem Nicht-Diagonalelement in der $m$-ten Zeile der Matrix $\underline{T}$ entspricht.

Im darauffolgenden Verfahrensschritt S210 wird ein Normalisierungsfaktor $\alpha$ für die Rekursion gemäß Gleichung (51) aus den in Verfahrensschritt S200 ermittelten minimalen und maximalen Eigenwert $\lambda_{min}$ und $\lambda_{max}$ der zu invertierenden Matrix $\underline{\widetilde{H}}^H \cdot \underline{\widetilde{H}} + \varepsilon \underline{I}$ berechnet.

Der nächste Verfahrensschritt S220 beinhaltet die Berechnung der Matrix $\underline{X}$ als Faktor der für die Näherung der Matrixinversion zu entwickelnden Taylor-Reihe gemäß Gleichung (44) in Abhängigkeit des Normalisierungsfaktors

$\alpha$, der zu invertierenden Matrix $\widetilde{H}H \cdot \widetilde{H}+\varepsilon I$ und der Einheitsmatrix $I$.

Im darauffolgenden Verfahrensschritt S230 wird die Rekursionsvariable $\underline{d}^{(1)}$ zum Rekursionsschritt $i$=1 für die rekursive Berechnung des Vektors $\widetilde{w}$ des/r Vorfilters 6 bzw. 6$^{(1)}$, 6$^{(2)}$, ... , 6$^{(n)}$ gemäß Gleichung (47B) i.V.m. Gleichung (41) initialisiert.

Im nächsten Verfahrensschritt S240 wird überprüft, ob die Anzahl der bereits durchgeführten Rekursionen $i$ unterhalb der maximalen Anzahl $N$ von durchzuführenden Rekursionen liegt und somit ein weiterer Rekursionsschritt durchzuführen ist.

Liegt die Anzahl $i$ der bereits durchgeführten Rekursionen unterhalb der maximalen Anzahl $N$ von durchzuführenden Rekursionen, so wird im nächsten Verfahrensschritt S250 die Rekursionsvariable $\underline{d}^{(i+1)}$ zum Rekursionsschritt $i$+1 für die rekursive Berechnung des Vektors $\widetilde{w}$ der Filterkoeffizienten des/r Vorfilters 6 bzw. 6$^{(1)}$, 6$^{(2)}$, ... , 6$^{(n)}$ rekursiv aus der Rekursionsariable $\underline{d}^{(i)}$ zum vorherigen Rekursionsschritt $i$, der Matrix $\underline{X}$ und der in Verfahrensschritt S230 vorinitialisierten Rekursionsvariable $\underline{d}^{(1)}$ gemäß Gleichung (47A) i.V.m. Gleichung (41) berechnet.

Entspricht die Anzahl $i$ der bereits durchgeführten Rekursionen der maximalen Anzahl $N$ von durchzuführenden Rekursionen, so wird in Verfahrensschritt S260 die nach insgesamt $N$ durchgeführten Rekursionen rekursiv berechnete Rekursionsvariable $\underline{d}^{(N)}$ als optimierter Wert $\widetilde{w}_{opt}$ für die Filterkoeffizienten $\widetilde{w}$ des/r Vorfilters 6 bzw. 6$^{(1)}$, 6$^{(2)}$, ...,6$^{(n)}$ identifiziert.

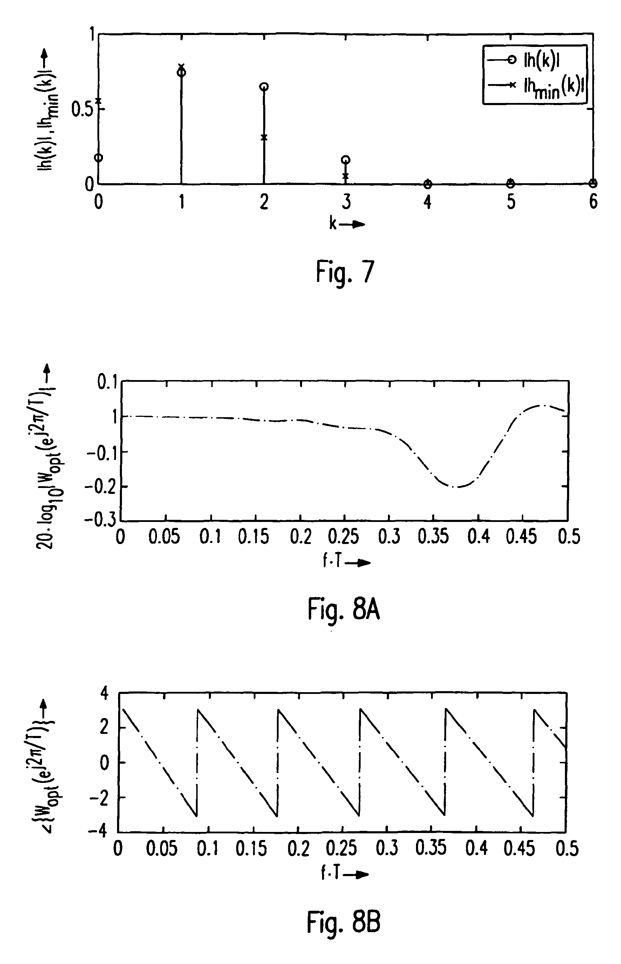

Im Zeitdiagramm der Fig. 7 ist der Betrag der Impulsantwort $|h(k)|$ der Übertragungsstrecke mit nicht-minimal-phasiger Übertragungsstrecke im Vergleich zum Betrag der Impulsantwort $|h_{min}(k)|$ der erfindungsgemäßen Übertragungsstrecke mit minimal-phasiger Übertragungsstrecke dargestellt. Zu erkennen ist die deutliche Signalenergiekompression am Beginn der minmal-phasigen Impulsantwort $|h_{min}(k)|$, die eine technisch vorteilhafte Reduzierung der Anzahl von Zuständen und Pfaden im Trellisdiagramm bei der Entzerrung des Empfangsignals bewirkt.

In Fig. 8A und 8B ist der Amplituden- und Phasengang des/r Vorfilters 6 bzw. 6$^{(1)}$, 6$^{(2)}$, ..., 6$^{(n)}$ dargestellt, der nach erfindungsgemäßer Auslegung gemäß Gleichung (2) die Übertragungscharakteristik eines Allpassfilters aufweist. Dies ist am weitestgehend frequenzinvarianten Amplitudengang und am phasenlinearen Phasengang des/r als Allpassnäherung entworfenen Vorfilter 6 bzw. 6$^{(1)}$, 6$^{(2)}$, ..., 6$^{(n)}$ zu erkennen.

Die Erfindung ist nicht auf die dargestellten Ausführungsformen beschränkt. Andere numerische und systemtheoretische Verfahren zur Ermittlung der Filterkoeffizienten des/r Vorfilter sind ebenfalls von der Erfindung abgedeckt.


## Patentansprüche

1. Verfahren zur Optimierung einer Übertragungsstrecke mit einer minimal-phasigen Übertragungscharakteristik (9; 9') aus einer Übertragungsstrecke mit einer nicht-minimal-phasigen Übertragungscharakteristik (8) vor einem Entzerrer (7) durch Bildung der Übertragungsstrecke mit minimal-phasiger Übertragungscharakteristik (9;9') aus einer Übertragungsstrecke mit nicht-minimal-phasigen Übertragungscharakteristik (8) und einem Vorfilter (6;6$^{(1)}$, 6$^{(2)}$,..., 6$^{(n)}$),

   wobei zur Bestimmung der Übertragungscharakteristik ($H_{min}(z)$) der Übertragungsstrecke mit minimal-phasiger Übertragungscharakteristik (9;9') das Cepstrum der Übertragungscharakteristik ($H(z)$) der Übertragungsstrecke mit nicht-minimal-phasigen Übertragungscharakteristik (8) benutzt wird, und

   wobei zur Bestimmung der Übertragungscharakteristik ($H_{min}(z)$) der Übertragungsstrecke mit minimal-phasiger Übertragungscharakteristik (9;9') einzig die Übertragungscharakteristik ($H(z)$) der Übertragungsstrecke mit nicht-minimal-phasiger Übertragungscharakteristik (8) herangezogen wird,

   **dadurch gekennzeichnet,**

   **dass** die Filterkoeffizienten ($\widetilde{w}$) zur Aufwandsminimierung gegenüber einer bei großen Filterlängen ($L_h$) des Vorfilters (6; 6$^{(1)}$, 6$^{(2)}$,..., 6$^{(n)}$) komplexen Matrixinversion rekursiv berechnet werden.

2. Verfahren nach Anspruch 1,
   **dadurch gekennzeichnet,**
   **dass** die Filterkoeffizienten ($\widetilde{w}$) des Vorfilters (6; 6$^{(1)}$, 6$^{(2)}$, ... , 6$^{(n)}$) durch Minimierung der Fehlerquadrate zwischen einem mit den Filterkoeffizienten ($\widetilde{w}$) des Vorfilters (6; 6$^{(1)}$, 6$^{(2)}$,...,6$^{(n)}$) gewichteten, am Ausgang der Übertragungsstrecke mit nicht-minimal-phasiger Übertragungscharakteristik (8) empfangenen Signal ($\widetilde{r}$) und einer mit der zur Übertragungsstrecke mit minimal-phasiger Übertragungscharakteristik (9,9') gehörigen Impulsantwort ($\underline{\widetilde{h}}_{min}$) gefalteten gesendeten Datensymbol-Sequenz ($\underline{d}_D$) ermittelt werden.

3. Verfahren nach Anspruch 2,
   **dadurch gekennzeichnet,**
   **dass** bei der Ermittlung der Filterkoeffizienten ($\widetilde{w}$) des Vorfilters (6; 6$^{(1)}$, 6$^{(2)}$,...,6$^{(n)}$) zusätzlich die Norm ($\|\widetilde{w}\|$) über die Filterkoeffizienten ($\widetilde{w}$) minimiert wird.

**4.** Verfahren nach einem der Ansprüche 1 bis 3,
**dadurch gekennzeichnet,**
**dass** die Filterkoeffizienten $\tilde{w}$ nach folgender mathematischer Formel berechnen werden:

$$\underline{\tilde{w}}^{H} = \underline{\tilde{h}}^{H}_{\min} \cdot \underline{R}_{DD} \cdot \underline{\tilde{H}} \cdot \left( \underline{\tilde{H}}^{H} \cdot \underline{R}_{DD} \cdot \underline{\tilde{H}} + \varepsilon \cdot \underline{I} \right)^{-1}$$

wobei

$\underline{R}_{DD}$ eine Rauschkorrelationsmatrix der gesendeten Datensymbol-Sequenz $d_D$,
$\underline{H}$ eine Matrix mit Kanalkoeffizienten der Übertragungsstrecke mit nicht-minimal-phasiger Übertragungscharakteristik,
$\varepsilon$ eine kleine reelle Konstante
$\underline{I}$ die Einheitsmatrix und
$\tilde{h}_{\min}$ die Impulsantwort der Übertragungsstrecke ist.

**5.** Verfahren nach Anspruch 4,
**dadurch gekennzeichnet,**
**dass** die rekursive Berechnung der Filterkoeffizienten $\tilde{w}$ mit folgenden Verfahrensschritten erfolgt:

• explizite Berechnung eines maximalen Eigenwertes $\lambda_{MAX}$ und eines minimalen Eigenwertes $\lambda_{MIN}$ der Matrix $\underline{\tilde{H}}^{H} \cdot R_{DD} \cdot \underline{\tilde{H}} + \varepsilon \cdot I$ oder Schätzung des maximalen Eigenwertes $\lambda_{MAX}$ und des minimalen Eigenwertes $\lambda_{MIN}$ nach dem Gerschgorin-Theorem,
• Berechnen eines Normalisierungsfaktors $\alpha$ gemäß der mathematischen Formel:

$$\alpha = \frac{2}{\lambda_{MAX} + \lambda_{MIN} + 2 \cdot \varepsilon}\,,$$

• Initialisieren einer Rekursionsvariable $\underline{d}^{(1)}$ für die Filterkoeffizienten $\tilde{w}$ gemäß der mathematischen Formel:

$$\underline{d}^{(1)} = \alpha \cdot \underline{\tilde{h}}^{H}_{\min} \cdot \underline{R}_{DD} \cdot \underline{\tilde{H}}\,,$$

• N-faches rekursives Berechnen der Rekursionsvariable $\underline{d}^{(i+1)}$ für die Filterkoeffizienten $\tilde{w}$ gemäß der mathematischen Formel:

$$\underline{d}^{(i+1)} = \alpha \cdot \underline{\tilde{h}}^{H}_{\min} \cdot \underline{R}_{DD} \cdot \underline{\tilde{H}} - \left[ \alpha \cdot \left( \underline{\tilde{H}}^{H} \cdot \underline{R}_{DD} \cdot \underline{\tilde{H}} + \varepsilon \cdot \underline{I} \right) - \underline{I} \right] \cdot \underline{d}^{(i)}$$

und
• Bestimmung der Filterkoeffizienten $\tilde{w}$ aus der im $N$-ten Rekursionsschritt berechneten Rekursionsvariable $\underline{d}^{(N)}$.

**6.** Verfahren nach Anspruch 1,
**dadurch gekennzeichnet,**
**dass** die Filterkoeffizienten $\tilde{w}$ des Vorfilters (6; 6[(1)], 6[(2)], ... , 6[(n)]) durch Lösen eines linearen Gleichungssystems zwischen einem mit einer Übertragungsmatrix $\underline{H}$ der Übertragungsstrecke mit nicht-minimal-phasiger Übertragungscharakteristik multiplizierten Vektor der Filterkoeffizienten $\tilde{w}$ des Vorfilters (6; 6[(1)], 6[(2)], ...,6[(n)]) und einem Vektor der Impulsantwort $\underline{h}_{\min}$ der Übertragungsstrecke mit minimal-phasiger Übertragungscharakteristik ermittelt werden.

**7.** Verfahren nach Anspruch 6,
**dadurch gekennzeichnet,**
**dass** die Filterkoeffizienten $\tilde{w}$ nach folgender mathematischer Formel berechnet werden:

$$\widetilde{w} = (\widetilde{\underline{H}}^{H} \cdot \widetilde{\underline{H}} + \varepsilon \cdot \underline{I})^{-1} \cdot \widetilde{\underline{H}}^{H} \cdot \left[ \underline{0}_{1 \times (L_{AP}-1)}, \quad \underline{h}_{\min}^{T} \right]^{T}$$

wobei

$\varepsilon$ eine kleine reelle Konstante und
$\underline{I}$ die Einheitsmatrix ist.

8. Verfahren nach Anspruch 7,
**dadurch gekennzeichnet,**
**dass** die <u>rekursive</u> Berechnung der Filterkoeffizienten <u>w</u> mit folgenden Verfahrensschritten erfolgt:

• explizite Berechnung eines maximalen Eigenwertes $\lambda_{MAX}$ und eines minimalen Eigenwertes $\lambda_{MIN}$ der Matrix $\underline{H}^{H} \cdot \underline{H} + \varepsilon \cdot \underline{I}$ oder Schätzung des maximalen Eigenwertes $\lambda_{MAX}$ und des minimalen Eigenwertes $\lambda_{MIN}$ nach dem Gersch-gorin-Theorem,
• Berechnen eines Normalisierungsfaktors $\alpha$ gemäß der mathematischen Formel:

$$\alpha = \frac{2}{\lambda_{MAX} + \lambda_{MIN} + 2 \cdot \varepsilon},$$

• Initialisieren einer Rekursionsvariable $\underline{d}^{(1)}$ für die Filterkoeffizienten $\widetilde{w}$ gemäß der mathematischen Formel:

$$\underline{d}^{(1)} = \alpha \cdot \widetilde{\underline{h}}_{\min}^{H} \cdot \widetilde{\underline{H}},$$

• $N$-faches rekursives Berechnen der Rekursionsvariable $d^{(i+1)}$ für die Filterkoeffizienten $\widetilde{w}$ gemäß der mathematischen Formel:

$$\underline{d}^{(i+1)} = \alpha \cdot \widetilde{\underline{h}}_{\min}^{H} \cdot \widetilde{\underline{H}} - \left[ \alpha \cdot \left( \widetilde{\underline{H}}^{H} \cdot \widetilde{\underline{H}} + \varepsilon \cdot \underline{I} \right) - \underline{I} \right] \cdot \underline{d}^{(i)}$$

und
• Bestimmung der Filterkoeffizienten $\widetilde{w}$ aus der im $N$-ten Rekursionsschritt berechneten Rekursionsvariable $\underline{d}^{(N)}$.

9. Verfahren nach einem der Ansprüche 1 bis 8,
**dadurch gekennzeichnet,**
**dass** die Anzahl von zu berechnenden Filterkoeffizienten bei einer Abtastung des Empfangssignals im $n$-fachen Symboltakt gegenüber der Anzahl von zu berechnenden Filterkoeffizienten bei der Abtastung des Empfangssignals im vollen Symboltakt um den Faktor $n$ erhöht ist.

10. Übertragungssystem mit einer Übertragungsstrecke mit einer minimal-phasigen Übertragungscharakteristik (9; 9'), die einem Entzerrer (7) vorgeschaltet ist, mit einer Übertragungsstrecke mit einer nicht-minimal-phasigen Übertragungscharakteristik (3) und einem nachgeschalteten Vorfilter (6;6$^{(1)}$, 6$^{(2)}$, ..., 6$^{(n)}$, wobei die Übertragungscharakteristik ($H_{\min}(z)$) der Übertragungsstrecke mit minimal-phasiger Übertragungscharakteristik (9;9') aus dem Cepstrum der Übertragungscharakteristik ($H(z)$) der Übertragungsstrecke mit nicht-minimal-phasigen Übertragungscharakteristik (8) gewonnen ist und wobei die Übertragungscharakteristik ($H_{\min}(z)$) der Übertragungsstrecke mit minimal-phasiger Übertragungscharakteristik (9;9') einzig aus der Übertragungscharakteristik (H(z)) der Übertragungsstrecke mit nicht-minimal-phasiger Übertragungscharakteristik (8) bestimmt ist,
**dadurch gekennzeichnet,**
**dass** die Filterkoeffizienten ($\widetilde{w}$) <u>zur Aufwandsminimierung gegenüber einer bei großen Filterlängen ($L_h$) des Vorfilters (6; 6$^{(1)}$,6$^{(2)}$, ... , 6$^{(n)}$) komplexen Matrixinversion rekursiv berechnet werden.</u>

**11.** Übertragungssystem nach Anspruch 10,
**dadurch gekennzeicnet,**
dass die Filterkoeffizienten ($\widetilde{w}$) des Vorfilters (6;6$^{(1)}$, 6$^{(2)}$, ... , 6$^{(n)}$) durch Minimierung der Fehlerquadrate zwischen einem mit den Filterkoeffizienten ($\widetilde{w}$) des Vorfilters (6; 6$^{(1)}$, 6$^{(2)}$,..., 6$^{(n)}$ ) gewichteten, am Ausgang der Übertragungsstrecke mit nicht-minimal-phasiger Übertragungscharakteristik (8) empfangenen Signal ($\widetilde{r}$) und der mit der zur Übertragungsstrecke mit nicht-minimal-phasiger Übertragungscharakteristik (9;9') gehörigen Impulsantwort ($\widetilde{h}_{min}$) gefalteten gesendeten Datensymbol-Sequenz ($\underline{d}_D$) bestimmt sind.

**12.** Übertragungssystem nach Anspruch 10 oder 11,
**dadurch gekennzeichnet,**
**dass** die Filterkoeffizienten ($\widetilde{w}$) des Vorfilters (6 ; 6$^{(1)}$, 6 $^{(2)}$, ...,6$^{(n)}$ ) durch Lösen eines linearen Gleichungssystems zwischen einem mit einer Übertragungsmatrix ($\underline{H}$) der Übertragungsstrecke mit nicht-minimal-phasiger Übertragungscharakteristik multiplizierten Vektor der Filterkoeffizienten ($\underline{\widetilde{w}}$) des Vorfilters (6; 6$^{(1)}$, 6$^{(2)}$ , ... , 6$^{(n)}$) und einem Vektor der Impulsantwort ($\underline{\widetilde{h}}_{min}$) der Übertragungsstrecke mit minimal-phasiger Übertragungscharakteristik bestimmt sind.

**13.** Übertragungssystem nach einem der Ansprüche 10 bis 12, ,
**dadurch gekennzeichnet,**
**dass** dem Vorfilter (6;6$^{(1)}$,6$^{(2)}$, ...,6$^{(n)}$) ein Abtaster (5) zur Abtastung eines am Ausgang der Übertragungsstrecke mit nicht-minimal-phasiger Übertragungscharakteristik (8) empfangenen Signals ($\widetilde{r}$) im vollen oder $n$-fachen Symboltakt des empfangenen Signals ($\widetilde{r}$) vorgeschaltet ist.

**14.** Übertragungssystem nach Anspruch 13,
**dadurch gekennzeichnet,**
**dass** bei Abtastung des empfangenen Signals ($\widetilde{r}$) im $n$-fachen Symboltakt jeweils $n$ identische Vorfilter (6$^{(1)}$, 6$^{(2)}$, ..., 6$^{(n)}$) parallel geschaltet sind, denen jeweils zyklisch über einen ersten Umschalter (10) jeder $n$-te Abtastwert des empfangenen Signals ($\widetilde{r}$) zugeführt wird.

**15.** Übertragungssystem nach Anspruch 14,
**dadurch gekennzeichnet,**
**dass** bei Abtastung des empfangenen Signals ($\widetilde{r}$) im $n$ - fachen Symboltakt den $n$ parallel geschalteten Vorfiltern (6$^{(1)}$,6$^{(2)}$ ,...,6$^{(n)}$ ) ein zweiter Umschalter (11) zur Bündelung von an den Ausgängen der $n$ parallel geschalteten Vorfilter (6$^{(1)}$, 6$^{(2)}$ ,...,6$^{(n)}$) jeweils anliegenden, vorgefilterten Empfangssignale ($r'(k)^{(1)}$, $r'(k)^{(2)}$, ... , $r'(k)^{(n)}$) in einem dem Entzerrer (7) zugeführten Empfangssignal ($r'(k)$) nachgeschaltet ist.

**Claims**

**1.** A method for optimising a transmission path with a minimal-phase transmission characteristic (9; 9') from a transmission path with a non-minimal-phase transmission characteristic (8) upstream of an equaliser (7) by forming the transmission path with minimal-phase transmission characteristic (9; 9') from a transmission path with non-minimal-phase transmission characteristic (8) and a pre-filter (6; 6$^{(1)}$, 6$^{(2)}$, , ..., 6$^{(n)}$),
Wherein, in order to determine the transmission characteristic ($H_{min}(z)$) of the transmission path with minimal-phase transmission characteristic (9; 9'), the cepstrum of the transmission characteristic ($H(z)$) of the transmission path with non-minimal-phase transmission characteristic (8) is used, and
wherein in order to determine the transmission characteristic ($H_{min}(z)$) of the transmission path with minimal-phase transmission characteristic (9; 9'), exclusively the transmission characteristic ($H(z)$) of the transmission path with non-minimal-phase transmission characteristic (8) is used,
**characterised in that**
the filter coefficients ($\widetilde{w}$) are calculated recursively in order to minimise costs relative to a complex matrix inversion with large filter lengths ($L_h$) of the pre-filter (6; 6$^{(1)}$, 6$^{(2)}$, ..., 6$^{(n)}$).

**2.** The method according to claim 1,
**characterised in that**
the filter coefficients ($\widetilde{w}$) of the pre-filter (6; 6$^{(1)}$ , 6$^{(2)}$ , ..., 6$^{(n)}$) are determined by minimising the error squares between a signal ($\underline{r}$) weighted with the filter coefficients ($\widetilde{w}$) of the pre-filter (6; 6$^{(1)}$, 6$^{(2)}$, ..., 6$^{(n)}$), received at the output of the transmission path with non-minimal-phase transmission characteristic (8) and a transmitted data-symbol sequence ($\underline{d}_D$) convoluted with the impulse response ($\underline{\widetilde{h}}_{min}$) associated with the transmission path with minimal-phase transmission characteristic (9; 9').

3. The method according to claim 2,
   **characterised in that**,
   in determining the filter coefficients ($\tilde{w}$) of the pre-filter (6; $6^{(1)}$, $6^{(2)}$, ..., $6^{(n)}$) the standard ($\|\tilde{w}\|$) is additionally minimised via the filter coefficients ($\tilde{w}$).

4. The method according to any one of claims 1 to 3,
   **characterised in that**
   the filter coefficients ($\tilde{w}$) are calculated according to the following mathematical formula:

$$\tilde{w}^H = \tilde{\underline{h}}_{\min}^H \cdot \underline{R}_{DD} \cdot \tilde{\underline{H}} \cdot (\tilde{\underline{H}}^H \cdot \underline{R}_{DD} \cdot \tilde{\underline{H}} + \varepsilon \cdot \underline{I})^{-1}$$

wherein

$\underline{R}_{DD}$ denotes a noise correlation matrix of the transmitted data symbol sequence $d_D$,
$\tilde{\underline{H}}$ denotes a matrix with channel coefficients of the transmission path with non-minimal-phase transmission characteristic,
$\varepsilon$ denotes a small real constant
$\underline{I}$ denotes the unit matrix and
$\tilde{\underline{h}}_{\min}$ denotes the impulse response of the transmission path.

5. The method according to claim 4,
   **characterised in that**
   the <u>recursive</u> calculation of the filter coefficients $\tilde{w}$ is implemented with the following method steps:

   - explicit calculation of a maximal eigenvalue $\lambda_{MAX}$ and of a minimal eigenvalue $\lambda_{MIN}$ of the matrix $\tilde{\underline{H}}^H \cdot \underline{R}_{DD} \cdot \tilde{\underline{H}} + \varepsilon \cdot \underline{I}$ or estimation of the maximal eigenvalue $\lambda_{MAX}$ and of the minimal eigenvalue $\lambda_{MIN}$ according to Gerschgorin's theorem,
   - calculation of a normalisation factor $\alpha$ according to the mathematical formula:

$$\alpha = \frac{2}{\lambda_{MAX} + \lambda_{MIN} + 2 \cdot \varepsilon}$$

   - initialisation of a recursion variable $\underline{d}^{(1)}$ for the filter coefficients $\tilde{w}$ according to the mathematical formula:

$$\underline{d}^{(1)} = \alpha \cdot \tilde{\underline{h}}_{\min}^H \cdot \underline{R}_{DD} \cdot \tilde{\underline{H}}$$

   - N-fold recursive calculation of the recursion variable $\underline{d}^{(i+1)}$ for the filter coefficients $\tilde{w}$ according to the mathematical formula:

$$\underline{d}^{(i+1)} = \alpha \cdot \tilde{\underline{h}}_{\min}^H \cdot \underline{R}_{DD} \cdot \tilde{\underline{H}} - \left[ \alpha \cdot (\tilde{\underline{H}}^H \cdot \underline{R}_{DD} \cdot \tilde{\underline{H}} + \varepsilon \cdot \underline{I}) - \underline{I} \right] \cdot \underline{d}^{(1)}$$

   and
   - determination of the filter coefficients $\tilde{\underline{w}}$ from the recursion variable $\underline{d}^{(N)}$ calculated in the N-th recursion step.

**6.** The method according to claim 1,
**characterised in that**
the filter coefficients $\tilde{w}$ of the pre-filter (6; $6^{(1)}$, $6^{(2)}$, ..., $6^{(n)}$) are determined by resolving a linear equation system between a vector of the filter coefficients $\tilde{w}$ of the pre-filter (6; $6^{(1)}$, $6^{(2)}$, ..., $6^{(n)}$) multiplied by a transmission matrix $\tilde{H}$ of the transmission path with non-minimal-phase transmission characteristic and a vector of the impulse response $\tilde{h}_{min}$ of the transmission path with minimal-phase transmission characteristic.

**7.** The method according to claim 6,
**characterised in that**
the filter coefficients $\tilde{w}$ are calculated according to the following mathematical formula:

$$\tilde{w} = (\tilde{\underline{H}}^H \cdot \tilde{\underline{H}} + \varepsilon \cdot \underline{I})^{-1} \cdot \tilde{\underline{H}}^H \cdot \left[ \underline{0}_{1 \times (L_{AP-1})}, h_{min}^T \right]^T$$

wherein

$\varepsilon$ denotes a small real constant and
$\underline{I}$ denotes the unit matrix.

**8.** The method according to claim 7,
**characterised in that**
the <u>recursive</u> calculation of the filter coefficients $\tilde{w}$ is implemented with the following method steps:

- explicit calculation of a maximal eigenvalue $\lambda_{MAX}$ and of a minimal eigenvalue $\lambda_{MIN}$ of the matrix $\tilde{\underline{H}}^H \cdot \tilde{\underline{H}} + \varepsilon \cdot \underline{I}$ or estimation of the maximal eigenvalue $\lambda_{MAX}$ and of the minimal eigenvalue $\lambda_{MIN}$ according to Gerschgorin's theorem,
- calculation of a normalisation factor $\alpha$ according to the mathematical formula:

$$\alpha = \frac{2}{\lambda_{MAX} + \lambda_{MIN} + 2 \cdot \varepsilon} \, ,$$

- initialisation of a recursion variable $\underline{d}^{(1)}$ for the filter coefficients $\tilde{w}$ according to the mathematical formula:

$$\underline{d}^{(1)} = \alpha \cdot \tilde{\underline{h}}_{min}^H \cdot \tilde{\underline{H}}$$

- N-fold recursive calculation of the recursion variable $\underline{d}^{(i+1)}$ for the filter coefficients $\tilde{w}$ according to the mathematical formula:

$$\underline{d}^{(i+1)} = \alpha \cdot \tilde{\underline{h}}_{min}^H \cdot \tilde{\underline{H}} - \left[ \alpha \cdot (\tilde{\underline{H}}^H \cdot \tilde{\underline{H}} + \varepsilon \cdot \underline{I}) - \underline{I} \right] \cdot \underline{d}^{(i)}$$

and
- determination of the filter coefficients $\tilde{w}$ from the recursion variable $\underline{d}^{(N)}$ calculated in the N-th recursion step.

**9.** The method according to any one of claims 1 to 8,
**characterised in that**

the number of filter coefficients to be calculated with a sampling of the received signal at the $n$-fold symbol clock pulse is increased by the factor $n$ relative to the number of filter coefficients to be calculated with a sampling of the received signal at the full symbol clock pulse.

**10.** A transmission system with a transmission path with a minimal-phase transmission characteristic (9; 9'), which is connected upstream of an equaliser (7), with a transmission path with a non-minimal-phase transmission characteristic (3) and a pre-filter (6; $6^{(1)}$, $6^{(2)}$, ..., $6^{(n)}$) connected downstream,
wherein the transmission characteristic ($H_{min}$ (z) ) of the transmission path with minimal-phase transmission characteristic (9; 9') is obtained from the cepstrum of the transmission characteristic ($H(z)$) of the transmission path with non-minimal-phase transmission characteristic (8) and
wherein the transmission characteristic ($H_{min}(z)$) of the transmission path with minimal-phase transmission characteristic (9; 9') is determined exclusively from the transmission characteristic ($H(z)$) of the transmission path with non-minimal-phase transmission characteristic (8),
<u>**characterised in that**</u>
<u>the filter coefficients ($\widetilde{w}$) are calculated recursively in order to minimise the cost by comparison with a complex matrix inversion with large filter lengths ($L_h$) of the pre-filter (6; $6^{(1)}$, $6^{(2)}$, ..., $6^{(n)}$ ).</u>

**11.** The transmission system according to claim 10,
**characterised in that**
the filter coefficients ($\widetilde{w}$) of the pre-filter (6; $6^{(1)}$, $6^{(2)}$, ..., $6^{(n)}$) are determined by minimising the error squares between a signal ($\widetilde{r}$) weighted with the filter coefficients ($\widetilde{w}$) of the pre-filter (6; $6^{(1)}$, $6^{(2)}$, ..., $6^{(n)}$), received at the output of the transmission path with non-minimal-phase transmission characteristic (8) and the transmitted data symbol sequence ($\underline{d}_D$) convoluted with the impulse response ($\widetilde{h}_{min}$) associated with the transmission path with non-minimal-phase transmission characteristic (9; 9').

**12.** The transmission system according to claim 10 or 11,
**characterised in** the
the filter coefficients ($\widetilde{w}$) of the pre-filter (6; $6^{(1)}$, $6^{(2)}$, ..., $6^{(n)}$) are determined by resolving a linear equation system between a vector of the filter coefficients ($\widetilde{w}$) of the pre-filter (6; $6^{(1)}$, $6^{(2)}$, ..., $6^{(n)}$) multiplied by a transmission matrix ($\underline{\widetilde{H}}$) of the transmission path with non-minimal-phase transmission characteristic and a vector of the impulse response ($\underline{\widetilde{h}}_{min}$) of the transmission path with minimal-phase transmission characteristic.

**13.** The transmission system according to any one of claims 10 to 12,
**characterised in that**
a sampler (5) for sampling a signal ($\underline{r}$) received at the output of the transmission path with non-minimal-phase transmission characteristic (8) at the full or $n$ -fold symbol clock pulse of the received signal ($\underline{r}$) is connected upstream of the pre-filter (6; $6^{(1)}$, $6^{(2)}$, $6^{(n)}$.

**14.** The transmission system according to claim 13,
**characterised in that**,
in the case of a sampling of the received signal ($\underline{r}$) at the $n$-fold symbol clock pulse, in each case, $n$ identical pre-filters (6; $6^{(1)}$, $6^{(2)}$, ..., $6^{(n)}$ are connected in parallel, to which respectively every $n$-th sampled value of the received signal ($\underline{r}$) is supplied in a cyclical manner via a first changeover switch (10).

**15.** The transmission system according to claim 14,
**characterised in that**,
in the case of a sampling of the received signal ($\underline{r}$) at the $n$-th symbol clock pulse, a second changeover switch (11) is connected downstream of the $n$ parallel-connected pre-filters (6; $6^{(1)}$, $6^{(2)}$, ..., $6^{(n)}$ in order to bundle pre-filtered received signals ($r'(k)^{(1)}, r'(k)^{(2)}, ..., r'(k)^{(n)}$) disposed respectively at the outputs of the $n$ parallel-connected pre-filters (6; $6^{(1)}$, $6^{(2)}$, ..., $6^{(n)}$) within a received signal ($r'(k)$) supplied to the equaliser (7).

**Revendications**

**1.** Procédé en vue de l'optimisation d'une voie de transmission comportant une caractéristique de transmission à phase minimale (9 ; 9') à partir d'une voie de transmission comportant une caractéristique de transmission à phase non minimale (8) en amont d'un égaliseur (7) par la formation de la voie de transmission à phase minimale (9; 9') à partir d'une voie de transmission comportant une caractéristique de transmission à phase non minimale (8) et un

préfiltre (6 ; $6^{(1)}$ ; $6^{(2)}$ ; ... ; $6^{(n)}$),
dans lequel, en vue de la détermination de la caractéristique de transmission ($H_{min}(z)$) de la voie de transmission comportant une caractéristique de transmission à phase minimale (9 ; 9'), le cepstre de la caractéristique de transmission ($H(z)$) de la voie de transmission à caractéristique de transmission à phase non minimale (8) est utilisé, et
dans lequel, en vue de la détermination de la caractéristique de transmission ($H_{min}(z)$) de la voie de transmission à caractéristique de transmission à phase minimale (9 ; 9'), seule la caractéristique de transmission ($H(z)$) de la voie de transmission à caractéristique de transmission à phase non minimale (8) est utilisée,
**caractérisé en ce que**
les coefficients de filtre ($\underline{\widetilde{w}}$) sont calculés de manière récursive en vue de la minimisation des coûts par rapport à une inversion de matrice complexe dans le cas de grandes longueurs de filtre **($L_h$)** du préfiltre (6 ; $6^{(1)}$ ; $6^{(2)}$;... ; $6^{(n)}$).

2. Procédé selon la revendication 1, **caractérisé en ce que**
les coefficients de filtre ($\underline{\widetilde{w}}$) du préfiltre (6 ; $6^{(1)}$ ; $6^{(2)}$ ; ... ; $6^{(n)}$) sont déterminés par minimisation du carré d'erreurs entre un signal ($\underline{\widetilde{r}}$) pondéré avec les coefficients de filtre ($\underline{\widetilde{w}}$) du préfiltre (6 ; $6^{(1)}$ ; $6^{(2)}$ ; ... ; $6^{(n)}$ et reçu à la sortie de la voie de transmission à caractéristique de transmission à phase non minimale (8) et une séquence de symboles de données ($\underline{d_D}$) envoyée jointe avec la réponse d'impulsion ($\underline{\widetilde{h}_{min}}$) associée à la voie de transmission à caractéristique de transmission à phase minimale (9, 9').

3. Procédé selon la revendication 2, **caractérisé en ce que**
lors de la détermination des coefficients de filtre ($\underline{\widetilde{w}}$) du préfiltre (6 ; $6^{(1)}$ ; $6^{(2)}$ ; ... ; $6^{(n)}$), la norme ($\|\underline{\widetilde{w}}\|$) concernant les coefficients de filtre ($\underline{\widetilde{w}}$) est également minimisée.

4. Procédé selon l'une des revendications 1 à 3, **caractérisé en ce que**
les coefficients de filtre ($\underline{\widetilde{w}}$) sont calculés selon la formule mathématique suivante :

$$\underline{\widetilde{w}}^H = \underline{\widetilde{h}}^H_{min} \cdot \underline{R}_{DD} \cdot \underline{\widetilde{H}} \cdot \left( \underline{\widetilde{H}}^H \cdot \underline{R}_{DD} \cdot \underline{\widetilde{H}} + \varepsilon \cdot \underline{I} \right)^{-1}$$

où

$\underline{R}_{DD}$ matrice de corrélation de bruit de la séquence de symboles de données envoyée $d_D$,
$\underline{H}$ matrice comportant des coefficients de canal de la voie de transmission à caractéristique de transmission à phase non minimale
$\varepsilon$ petite constante réelle
$\underline{I}$ matrice unité et
$\underline{\widetilde{h}}_{min}$ réponse d'impulsion de la voie de transmission.

5. Procédé selon la revendication 4, **caractérisé en ce que**
le calcul récursif des coefficients de filtre ($\underline{\widetilde{w}}$) est effectué grâce aux étapes de procédé suivantes :

• calcul explicite d'une valeur propre maximale $\lambda_{MAX}$ et d'une valeur propre minimale $\lambda_{MIN}$ de la matrice $\underline{\widetilde{H}}^H$ $\cdot \underline{R}_{DD} \cdot \underline{\widetilde{H}} + \varepsilon \cdot \underline{I}$ ou estimation de la valeur propre maximale $\lambda_{MAX}$ et de la valeur propre minimale $\lambda_{MIN}$ selon le théorème de Gerschgorin,
● calcul d'un facteur de normalisation $\alpha$ selon la formule mathématique :

$$\alpha = \frac{2}{\lambda_{MAX} + \lambda_{MIN} + 2 \cdot \varepsilon}$$

● initialisation d'une variable de récursion $\underline{d}^{(1)}$ pour les coefficients de filtre ($\underline{\widetilde{w}}$) selon la formule mathématique :

$$\underline{d}^{(1)} = \alpha \cdot \underline{\widetilde{h}}^H_{min} \cdot \underline{R}_{DD} \cdot \underline{\widetilde{H}}$$

● calcul récursif N fois de la variable de récursion $\underline{d}^{(i+1)}$ pour les coefficients de filtre $(\widetilde{\mathbf{w}})$ selon la formule mathématique :

$$\underline{d}^{(i+1)} = \alpha \cdot \widetilde{\underline{h}}^{H}_{min} \cdot \underline{R}_{DD} \cdot \widetilde{\underline{H}} - \left[\alpha \cdot \left(\widetilde{\underline{H}}^{H} \cdot \underline{R}_{DD} \cdot \widetilde{\underline{H}} + \varepsilon \cdot \underline{I}\right) - \underline{I}\right] \cdot \underline{d}^{(1)}$$

● détermination des coefficients de filtre $(\widetilde{\mathbf{w}})$ à partir de la variable de récursion $\underline{d}^{(N)}$ calculée au cours de la n-ième étape de récursion.

6. Procédé selon la revendication 1, **caractérisé en ce que**
   les coefficients de filtre $(\widetilde{\mathbf{w}})$ du préfiltre $(6 ; 6^{(1)} ; 6^{(2)} ; ... ; 6^{(n)})$ sont déterminés par résolution d'un système d'équations linéaires entre un vecteur multiplié par une matrice de transmission $\underline{H}$ de la voie de transmission à caractéristique de transmission à phase non minimale des coefficients de filtre $(\widetilde{\mathbf{w}})$ du préfiltre $(6 ; 6^{(1)} ; 6^{(2)} ; ... ; 6^{(n)})$ et un vecteur de la réponse d'impulsion $\widetilde{\underline{h}}_{min}$ de la voie de transmission à caractéristique de transmission à phase minimale.

7. Procédé selon la revendication 6, **caractérisé en ce que**
   les coefficients de filtre $(\widetilde{\mathbf{w}})$ sont calculés selon la formule mathématique suivante :

$$\widetilde{\underline{w}} = \left(\widetilde{\underline{H}}^{H} \cdot \widetilde{\underline{H}} + \varepsilon \cdot \underline{I}\right)^{-1} \cdot \widetilde{\underline{H}}^{H} \cdot \left[\underline{0}_{1 \times (L_{AP}-1)}, \underline{h}^{T}_{min}\right]^{T}$$

où

ε petite constante réelle et
$\underline{I}$ matrice unité.

8. Procédé selon la revendication 7, **caractérisé en ce que**
   le calcul récursif des coefficients de filtre $(\widetilde{\mathbf{w}})$ est effectué grâce aux étapes de procédé suivantes :

● calcul explicite d'une valeur propre maximale $\lambda_{MAX}$ et d'une valeur propre minimale $\lambda_{MIN}$ de la matrice $\widetilde{\underline{H}}^{\mathbf{H}} \cdot \widetilde{\underline{H}} + \varepsilon \cdot$ I ou évaluation de la valeur propre maximale $\lambda_{MAX}$ et de la valeur propre minimale $\lambda_{MIN}$ selon le théorème de Gerschgorin,
● calcul d'un facteur de normalisation $\alpha$ selon la formule mathématique :

$$\alpha = \frac{2}{\lambda_{MAX} + \lambda_{MIN} + 2 \cdot \varepsilon}$$

● initialisation d'une variable de récursion $\underline{d}^{(1)}$ pour les coefficients de filtre $(\widetilde{\mathbf{w}})$ selon la formule mathématique :

$$\underline{d}^{(1)} = \alpha \cdot \widetilde{\underline{h}}^{H}_{min} \cdot \widetilde{\underline{H}}$$

● calcul récursif n fois de la variable de récursion $\underline{d}^{(i+1)}$ pour les coefficients de filtre $(\widetilde{\mathbf{w}})$ selon la formule mathématique :

$$\underline{d}^{(i+1)} = \alpha \cdot \widetilde{\underline{h}}^{H}_{min} \cdot \widetilde{\underline{H}} - \left[ \alpha \cdot \left( \widetilde{\underline{H}}^{H} \cdot \widetilde{\underline{H}} + \varepsilon \cdot \underline{I} \right) - \underline{I} \right] \cdot \underline{d}^{(l)}$$

● évaluation des coefficients de filtre $(\widetilde{\underline{w}})$ à partir de la variable de récursion $\underline{d}^{(N)}$ calculée au cours de la N-ième étape de récursion.

**9.** Procédé selon l'une des revendications 1 à 8, **caractérisé en ce que**
le nombre de coefficients de filtre à calculer est augmenté du facteur n lors d'un échantillonnage du signal de réception au cours de la n-ième cadence de modulation par rapport au nombre de coefficients de filtre à calculer lors de l'échantillonnage du signal de réception au cours de toute la cadence de modulation.

**10.** Système de transmission comportant un voie de transmission à caractéristique de transmission à phase minimale $(9 ; 9')$, qui est placée en amont d'un égaliseur (7), comportant un voie de transmission à caractéristique de transmission à phase non minimale (8) et un préfiltre monté en aval $(6 ; 6^{(1)} ; 6^{(2)} ; ... ; 6^{(n)})$,
dans lequel la caractéristique de transmission $(H_{min}(z))$ de la voie de transmission à caractéristique de transmission à phase minimale $(9 ; 9')$ est produite à partir du cepstre de la caractéristique de transmission $(H(z))$ de la voie de transmission à caractéristique de transmission à phase non minimale (8) et
dans lequel seule la caractéristique de transmission $(H_{min}(z))$ de la voie de transmission à caractéristique de transmission à phase minimale $(9 ; 9')$ est déterminée à partir de la caractéristique de transmission $(H(z))$ de la voie de transmission à caractéristique de transmission à phase non minimale (8),
**caractérisé en que**
les coefficients de filtre $(\widetilde{\underline{w}})$ sont calculés de façon récursive en vue d'une minimisation des coûts par rapport à une inversion de matrice complexe dans le cas de grandes longueurs de filtre $(\underline{L_h})$ du préfiltre $(6 ; 6^{(1)} ; 6^{(2)}; ..... ; 6^{(n)})$.

**11.** Système de transmission selon la revendication 10, **caractérisé en que**
les coefficients de filtre $(\widetilde{\underline{w}})$ du préfiltre $(6 ; 6^{(1)} ; 6^{(2)} ; ... ; 6^{(n)}$ sont déterminés par minimisation du carré d'erreurs entre un signal $(\widetilde{\underline{r}})$ reçu à la sortie de la voie de transmission à caractéristique de transmission à phase non minimale (8) et pondéré par les coefficients de filtre $(\widetilde{\underline{w}})$ du préfiltre $(6 ; 6^{(1)} ; 6^{(2)} ; ... ; 6^{(n)})$ et une séquence de symboles de données $(\underline{d_D})$ envoyée jointe avec la réponse d'impulsion $(\underline{h}_{min})$ associée à la voie de transmission à caractéristique de transmission à phase minimale $(9 ; 9')$.

**12.** Système de transmission selon la revendication 10 ou 11, **caractérisé en ce que**
les coefficients de filtre $(\widetilde{\underline{w}})$ du préfiltre $(6 ; 6^{(1)} ; 6^{(2)} ; ... ; 6^{(n)})$ sont déterminés par résolution d'un système d'équations linéaires entre un vecteur multiplié par une matrice de transmission $(\widetilde{\underline{H}})$ de la voie de transmission à caractéristique de transmission à phase non minimale des coefficients de filtre $(\widetilde{\underline{w}})$ du préfiltre $(6 ; 6^{(1)} ; 6^{(2)} ; ... ; 6^{(n)})$ et un vecteur de la réponse d'impulsion $(\underline{h}_{min})$ de la voie de transmission à caractéristique de transmission à phase minimale.

**13.** Système de transmission selon l'une des revendications 10 à 12, **caractérisé en que**
un échantillonneur (5) est placé en amont du préfiltre $(6 ; 6^{(1)} ; 6^{(2)}; ... ; 6^{(n)})$ pour échantillonner un signal reçu $(\widetilde{\underline{r}})$ à la sortie de la voie de transmission à caractéristique de transmission à phase non minimale (8) au cours de toute ou de la n-ième cadence de modulation du signal reçu $(\widetilde{\underline{r}})$ .

**14.** Système de transmission selon la revendication 13, **caractérisé en ce que**
lors de l'échantillonnage du signal reçu $(\widetilde{\underline{r}})$ au cours de la n-ième cadence de modulation, n préfiltres identiques respectifs $(6 ; 6^{(1)} ; 6^{(2)}; ... ; 6^{(n)})$ sont montés en parallèle, auxquels est envoyée cycliquement respectivement chaque n-ième valeur d'échantillonnage du signal reçu $(\widetilde{\underline{r}})$ par l'intermédiaire d'un premier commutateur (10).

**15.** Système de transmission selon la revendication 14, **caractérisé en ce que**
lors de l'échantillonnage du signal reçu $(\widetilde{\underline{r}})$ au cours de la n-ième cadence de modulation, un second commutateur (11) est placé en aval des n préfiltres montés en parallèle $(6 ; 6^{(1)} ; 6^{(2)} ; ... ; 6^{(n)}$ en vue de la combinaison de signaux de réception $(r'(k)^{(1)}, r'(k)^{(2)},..., r'(k)^{(n)})$ placés en amont se trouvant respectivement aux sorties des n préfiltres montés en parallèle $(6 ; 6^{(1)} ; 6^{(2)} ; ... ; 6^{(n)})$ dans un signal de réception $(r'(k))$ envoyé à l'égaliseur (7).

Fig. 1A

Fig. 1B

Fig. 2A

Fig. 2C

O: Nullstelle
×: Polstelle

Fig. 2B

EP 2 135 414 B1

Fig. 3

Fig. 4

Start

Schätzen der Kanalimpulsantwort h(k) des Übertragungskanals mittels gängigen Schätzverfahrens — S10

Ermitteln der Koeffizienten $\hat{h}(k)$ der reellen Cepstrum−Funktion $\hat{H}(e^{j\omega n})$ aus der diskreten Kanalimpulsantwort h(k) — S20

Ermitteln der Koeffizienten $\hat{h}_{min}(k)$ der komplexen,minimal−phasigen Cepstrum− Funktion $\hat{H}_{min}(e^{j\omega n})$ aus den Koeffizienten $\hat{h}(k)$ der reellen Cepstrum−Funktion $\hat{H}(e^{j\omega n})$ — S30

Ermitteln der minimalphasigen Kanal− impulsantwort $h_{min}(k)$ der Übertragungs− strecke aus den Koeffizienten $\hat{h}_{min}(k)$ der komplexen minimal−phasigen Cepstrum− Funktion $\hat{H}(e^{j\omega n})$ — S40

Ermitteln der Filterkoeffizienten $\tilde{\underline{w}}$ bzw. $\tilde{\underline{w}}^{(1)}$ und $\tilde{\underline{w}}^{(2)}$ des/r Vorfilter aus der mini− malphasigen Kanalimpulsantwort $h_{min}(k)$ der Matrix d. Kanalkoeffizienten $\tilde{\underline{H}}$ bzw. $\tilde{\underline{H}}^{(1)}$ und $\tilde{\underline{H}}^{(2)}$ und u.U. der Rauschkorrelations− matrix $\underline{R}_{DD}$ — S50

Falten der Kanalkoffizienten der Matrix $\tilde{\underline{H}}$ der nicht−minimal−phasigen Übertraguns− strecke mit den Filterkoeffizienten $\tilde{\underline{w}}$ des/r Vorfilters zur Erzeugung einer Über− tragungsstrecke mit minimal−phasiger Übertragungscharakteristik — S60

Fig. 5

Ende

Start

explizites Berechnen oder Schätzen des maximalen und minimalen Eigenwerts $\lambda_{max}$ und $\lambda_{min}$ zu invertierenden Matrix $\underline{\tilde{H}}^H \cdot \underline{R}_{DD} \cdot \underline{\tilde{H}} + \varepsilon \underline{I}$ nach Gerschgorin-Theorem — S100

Ermitteln eines Normalisierungsfaktor $\alpha$ aus dem maximalen und minimalen Eigenwert $\lambda_{max}$ und $\lambda_{min}$ — S110

Berechnen der Matrix $\underline{X} = \alpha \left( \underline{\tilde{H}}^H \cdot \underline{R}_{DD} \cdot \underline{\tilde{H}} + \varepsilon \underline{I} \right) - I$ als Faktor der zu entwickelden Taylor-Reihe zur Näherung der Matrix-Inversion — S120

Initialisieren der Variable $\underline{d}^{(1)}$ für die Filter-Koeffizienten $\underline{\tilde{w}}$ des/r Vorfilters mit $\underline{d}^{(1)} = \alpha \cdot \tilde{h}_{min} \cdot \underline{R}_{DD} \cdot \underline{\tilde{H}}^H$ — S130

Anzahl der durchgführten Iterationen <N ? — 140

Ja          Nein

rekursives Berechnen der Variable $\underline{d}^{(i+1)}$ für die Filterkoeffizienten $\underline{\tilde{w}}$ gemäß der Rekursionsformel: $\underline{d}^{(i+1)} = \alpha \cdot \tilde{h}_{min} \cdot \underline{R}_{DD} \cdot \underline{\tilde{H}}^H - \underline{X} \cdot \underline{d}^{(i)}$ — 150

Zuweisung der Variable $\underline{d}^{(N)}$ nach N Rekursionen als optimaler Wert $\underline{\tilde{w}}_{opt}$ für die Filterkoeffizienten $\underline{\tilde{w}}$ des/r Vorfilters — 160

Ende

Fig. 6A

Start

explizites Berechnen oder Schätzen des maximalen und minimalen Eigenwerts $\lambda_{max}$ und $\lambda_{min}$ zu invertierenden Matrix $\tilde{\underline{H}}^H \cdot \tilde{\underline{H}} + \varepsilon\underline{I}$ nach Gerschgorin-Theorem ⟋-200

Ermitteln eines Normalisierungsfaktor $\alpha$ aus dem maximalen und minimalen Eigenwert $\lambda_{max}$ und $\lambda_{min}$ ⟋-S210

Berechnen der Matrix $\underline{X} = \alpha \cdot (\tilde{\underline{H}}^H \cdot \tilde{\underline{H}} + \varepsilon\underline{I}) - I$ als Faktor der zu entwickelden Taylor-Reihe zur Näherung der Matrix-Inversion ⟋-S220

Initialisieren der Variable $\underline{d}^{(1)}$ für die Filter-Koeffizienten $\tilde{\underline{w}}$ des/r Vorfilters mit $\underline{d}^{(1)} = \alpha \cdot \tilde{h}_{min} \cdot \tilde{\underline{H}}^H$ ⟋-S230

S240
Anzahl der durchgführten Iterationen <N ?
Ja          Nein

S250
rekursives Berechnen der Variable $\underline{d}^{(i+1)}$ für die Filterkoeffizienten $\tilde{\underline{w}}$ gemäß der Rekursionsformel:
$$\underline{d}^{(i+1)} = \alpha \cdot \tilde{h}_{min} \cdot \tilde{\underline{H}}^H - \underline{X} \cdot \underline{d}^{(i)}$$

Zuweisung der Variable $\underline{d}^{(N)}$ nach N Rekursionen als optimaler Wert $\tilde{\underline{w}}_{opt}$ für die Filterkoeffizienten $\tilde{\underline{w}}$ des/r Vorfilters ⟋-260

Fig. 6B

Ende

Fig. 7

Fig. 8A

Fig. 8B

**IN DER BESCHREIBUNG AUFGEFÜHRTE DOKUMENTE**

**In der Beschreibung aufgeführte Patentdokumente**

- WO 2007053086 A1
- US 5511014 A